# FASCICULE DE BREVET EUROPEEN

(11) **EP 2 634 875 B1**
(45) Date de publication et mention de la délivrance du brevet: **05.07.2017**
(21) Numéro de dépôt: 13305136.7
(22) Date de dépôt: 05.02.2013
(51) Int. Cl.: H02B 13/025, H02B 13/01

(54) **Bloc fonctionnel de mesure pour poste de distribution moyenne tension**
Messfeldblock für Mittelspannungsschaltanlage
Functional measuring group for medium-voltage distribution substation

(30) Priorité: 28.02.2012 FR 1200573
(43) Date de publication de la demande: 04.09.2013
(73) Titulaire: Schneider Electric Industries SAS, 92500 Rueil-Malmaison (FR)
(72) Inventeur: Furlano, Stéphane, 38050 Grenoble Cedex 09 (FR); Brunet, Sébastien, 38050 Grenoble Cedex 09 (FR); Toti-Buttin, Frédéric, 38050 Grenoble Cedex 09 (FR); Ferraro, Venanzio, 38050 Grenoble Cedex 09 (FR); Somegowda, Somesha, 38050 Grenoble Cedex 09 (FR)
(74) Mandataire: Colette, Marie-Françoise

(56) Documents cités:
- WO-A1-2009/010493
- DE-A1- 3 430 776

## Description

### DOMAINE TECHNIQUE

L'invention concerne l'optimisation d'un bloc de mesure pour poste de distribution moyenne tension, dans lequel l'agencement des différents éléments est associé à une simplification de la connexion entre appareillages électriques du poste pour une meilleure compacité et visibilité.

### ETAT DE LA TECHNIQUE

Dans les équipements électriques, en particulier dans les postes de distribution moyenne tension MT (aussi parfois appelés haute tension HTA), c'est-à-dire de l'ordre de 1 à 52 kV ou 75 kV, différents appareillages de type coupure et/ou mesure doivent être reliés électriquement entre eux ; qui plus est, au vu des tensions élevées et pour les protéger, il est avantageux d'isoler les liaisons par un surmoulage, et éventuellement de les blinder afin d'agumenter la compacité de l'ensemble et de diriger le champ électrique.

Différentes solutions ont été développées, avec notamment la mise en place de barres rigides reliées aux appareillages ; des connecteurs de type embrochable à cône externe ou interne selon la norme EN 50181 sont alors insérés. Une solution alternative permettant un encombrement réduit, notamment en hauteur, est présentée dans le document EP 2 063 495 ; cette solution utilisant des interfaces planes compressibles permet en outre de faciliter les procédés de raccordement.

L'utilisation de ce type de raccordement permet en outre, de par la simplicité et la compacité, de concevoir un bloc fonctionnel de mesure dont l'agencement est optimisé. De fait, les postes MT comprennent de façon usuelle des unités fonctionnelles permettant la mesure, notamment de la tension, mais ces unités sont très volumineuses en raison de l'agencement des capteurs. Les documents WO2009010493 A1, CH250180 et DE3430776 A1 présentent divers types de raccordement aux modules de mesure.

### EXPOSE DE L'INVENTION

Parmi autres avantages, l'invention vise à proposer un bloc fonctionnel de mesure pour un poste de distribution moyenne tension dont l'agencement est optimisé pour augmenter sa compacité et faciliter la mise en place et la maintenance.

L'invention se rapporte notamment à un bloc fonctionnel comprenant une enveloppe sensiblement parallélépipédique rectangle formée de deux logements séparés par une paroi. Un logement frontal du bloc comprend des moyens de mesure de la tension, localisés sur un plan vertical et de préférence directement accessibles par une porte du bloc parallèle audit plan ; avantageusement, les moyens de mesure de la tension comprennent trois capteurs de tension blindés, dont les bornes sont alignées selon une verticale et sont formées par un conducteur axial enrobé dans un support isolant duquel il débouche au centre d'un disque de raccordement par une surface de connexion.

Le deuxième logement du bloc de mesure loge les moyens de raccordement à un autre bloc fonctionnel d'un poste de distribution, lesdits moyens de raccordement pour l'entrée formant un premier plan horizontal parallèle à un deuxième plan formé par les moyens de raccordement pour l'entrée. Avantageusement, les moyens de raccordement du bloc comprennent chacun un insert conducteur intégré dans un support en matériau isolant et en débouchant au centre d'un disque de raccordement par une surface de connexion.

Les moyens de mesure de la tension sont reliés aux moyens de raccordement par l'intermédiaire d'un câble flexible muni à ses deux extrémités de dispositifs de raccordement adaptés à la borne des moyens de mesure et au moyen de raccordement concerné. Avantageusement, les dispositifs de raccordement du câble sont identiques et comprennent un support en matériau isolant déformable délimité par deux surfaces de raccordement opposées sensiblement parallèles et superposables aux disques de raccordement, ainsi qu'un insert de connexion conducteur enrobé dans le support isolant et débouchant des surfaces de raccordement par des surfaces de connexion opposées ; la hauteur de l'insert est inférieure à l'épaisseur du support de sorte qu'une compression entre les deux surfaces de raccordement permet une égalisation des distances et un raccordement électrique.

Le bloc de mesure peut également comprendre des moyens de mesure du courant, localisés dans le deuxième logement des moyens de raccordement, et directement accessibles depuis une deuxième face de l'enveloppe du bloc, notamment le haut. De préférence, les moyens de mesure du courant comprennent trois tores autour de barres de raccordement entre les moyens d'entrée et sortie du bloc. De préférence, les barres de raccordement comprennent à chaque extrémité des dispositifs de raccordement similaires à ceux des câbles, et les moyens de raccordement sont associés à des éléments auxiliaires permettant de modifier l'orientation des surfaces de raccordement, notamment des coudes munis de deux disques de raccordement.

L'invention concerne également une unité fonctionnelle dans laquelle le bloc de mesure est associé à un compartiment de passage de câble, et un poste de distribution comprenant uen juxtaposition d'unités fonctionnelles reliées entre elles par des barres de raccordement similaires à celles du bloc de mesure préféré.

Plus généralement, l'invention se rapporte à un bloc fonctionnel de mesure pour poste de distribution moyenne tension comprenant une enveloppe sensiblement parallélépipédique rectangle, trois moyens de raccordement pour l'arrivée de courant, trois moyens de raccordement pour la sortie de courant, et des moyens de mesure de la tension. Les moyens de raccordement à l'arrivée, respectivement à la sortie, sont alignés dans deux plans parallèles de l'enveloppe ; l'enveloppe comprend un premier logement pour les moyens de mesure de la tension, ledit compartiment étant accessible directement depuis une face d'accès de l'enveloppe orthogonale auxdits plans ; les moyens de mesure de la tension comprennent des bornes de raccordement localisées dans un plan parallèle à la face d'accès ; les bornes de raccordement des moyens de mesure sont reliées aux moyens de raccordement du bloc par l'intermédiaire de câbles flexibles. Les bornes des moyens de mesure de la tension et/ou les moyens de raccordement du bloc comprennent un conducteur axial enrobé dans un support isolant qui est revêtu partiellement d'un blindage, de sorte que la surface de raccordement de la borne est un disque dans lequel est centrée une surface de connexion du conducteur ; les moyens de raccordement d'entrée et de sortie du bloc sont raccordés entre eux par des barres de connexion munies à chaque extrémité d'un dispositif de raccordement comprenant : un support du matériau isolant délimité par deux surfaces de raccordement opposées sensiblement parallèles ; un insert de connexion conducteur intégré dans le support isolant et débouchant sur les deux surfaces de raccordement au niveau de deux surfaces de connexion planes parallèles, la hauteur de l'insert entre ses deux surfaces de connexion étant inférieure à la distance entre les deux surfaces de raccordement lorsque le matériau isolant du support est au repos, et supérieure ou égale à ladite distance lorsque le matériau est entièrement déformé par compression entre ses surfaces de raccordement.

### BREVE DESCRIPTION DES FIGURES

D'autres avantages et caractéristiques ressortiront plus clairement de la description qui suit de modes particuliers de réalisation de l'invention, donnés à titre illustratif et nullement limitatifs, représentés dans les figures annexées.
La figure 1 montre un poste de distribution moyenne tension selon un mode de réalisation préféré de l'invention.
Les figures 2A et 2B représentent une cellule de coupure et sectionnement dans deux configurations pour un poste selon un mode de réalisation de l'invention.
Les figures 3A et 3B montrent la connexion dans un poste de distribution selon un mode de réalisation de l'invention, avec notamment un exemple de barre de raccordement.
Les figures 4A et 4B illustrent les modifications d'autres éléments du poste de distribution pour optimiser la connexion préférée d'un poste selon l'invention.
La figure 5A représente un connecteur pour un poste de distribution préféré selon un mode de réalisation de l'invention, les figures 5B et 5C en illustrant deux modes de réalisation.
Les figures 6A, 6B et 6C montrent des agencements de connecteurs pour un poste de distribution selon l'invention.
La figure 7 représente une unité fonctionnelle de mesure pour un poste de distribution moyenne tension.
Les figures 8A et 8B illustrent un câble pour la connexion dans un poste de distribution selon un mode de réalisation de l'invention.
La figure 9 représente un élément pour la connexion dans un poste de distribution selon un mode de réalisation de l'invention.
La figure 10A montre l'enveloppe d'une unité fonctionnelle d'un poste de distribution selon un mode de réalisation préféré de l'invention, avec un schéma de l'écoulement des gaz ; la figure 10B représente un agrandissement d'un élément de l'enveloppe.

### DESCRIPTION DETAILLEE D'UN MODE DE REALISATION PREFERE

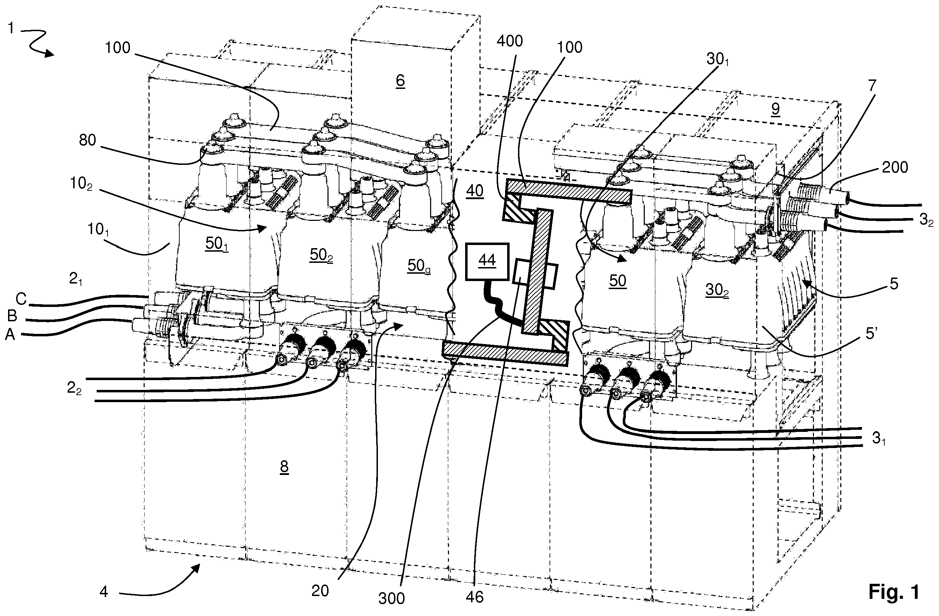

Tel qu'illustré en figure 1, un poste 1 de distribution électrique moyenne tension (MT) est mis en place entre l'arrivée 2 du réseau électrique et au moins un départ 3 de l'utilisateur qui alimente différentes charges. Au niveau du poste 1 sont assurées notamment des fonctions de coupure de courant et/ou de mise à la terre pour chaque phase d'alimentation A, B, C ; d'autres fonctions peuvent être ajoutées, en particulier des mesures de différents paramètres.

Les postes de distribution 1 comprennent ainsi plusieurs types d'appareils qui sont associés. Des systèmes modulaires sont connus, dans lesquels chaque unité fonctionnelle comprend les moyens de réaliser au moins une fonctionnalité et peut être associé à une autre unité fonctionnelle, du même type ou non, pour former un ensemble répondant au mieux aux besoins de l'utilisateur : voir par exemple l'offre SM6 de Schneider Electric. Une unité fonctionnelle 4 de poste MT 1 comprend une enveloppe, usuellement métallique, renfermant au moins un appareillage électrique, et munie de moyens permettant l'accès à des éléments de couplage entre unités 4, ainsi que vers l'extérieur 2, 3 ; avantageusement, toutes les unités sont de largeur identique, par exemple 375 mm, ou multiple du pas précédent. Classiquement, l'enveloppe est formée de plusieurs compartiments, dont en particulier un bloc fonctionnel MT 5 qui est entouré d'autres éléments remplissant différentes fonctions. Notamment, un boîtier 6 disposé au dessus est réservé aux appareillages basse tension de protection, contrôle et commande ; sa profondeur correspond classiquement à l'épaisseur du compartiment 5' de commande du bloc fonctionnel 5, et ses autres dimensions, notamment sa hauteur, peuvent varier en fonction en fonction des dispositifs qu'il loge. De préférence, le boîtier BT 6 est réalisé tel que décrit dans le document FR 2 950 202, et il peut être associé à une goulotte 7 permettant de « ranger » les câbles qui lui sont nécessaires, cette goulotte 7 pouvant également être prolongée verticalement dans le compartiment 5' de commande du bloc fonctionnel 5. En dessous du bloc fonctionnel 5 se trouve classiquement un compartiment bas 8 dédié à la gestion des câbles et arrivées/départs MT, avantageusement réalisé tel que décrit dans la demande de brevet FR 11 03799. Tel que précisé plus loin, le compartiment bas 8 est, dans le mode de réalisation préféré, aménagé pour l'écoulement des gaz, et de préférence associé à un compartiment arrière 9 de l'unité fonctionnelle 5 pour optimiser ledit écoulement.

Le bloc MT 5 peut remplir différentes fonctions, et notamment correspondre à un bloc de coupure 10, 20, 30 ou un bloc de mesure 40. Dans le cadre de la coupure, le module fonctionnel 5 comprend en face avant un compartiment de commande 5' et l'appareillage électrique 50 de coupure des trois phases A, B, C est logé dans une enveloppe 12 usuellement réalisée en tôle métallique et de forme parallélépipédique.

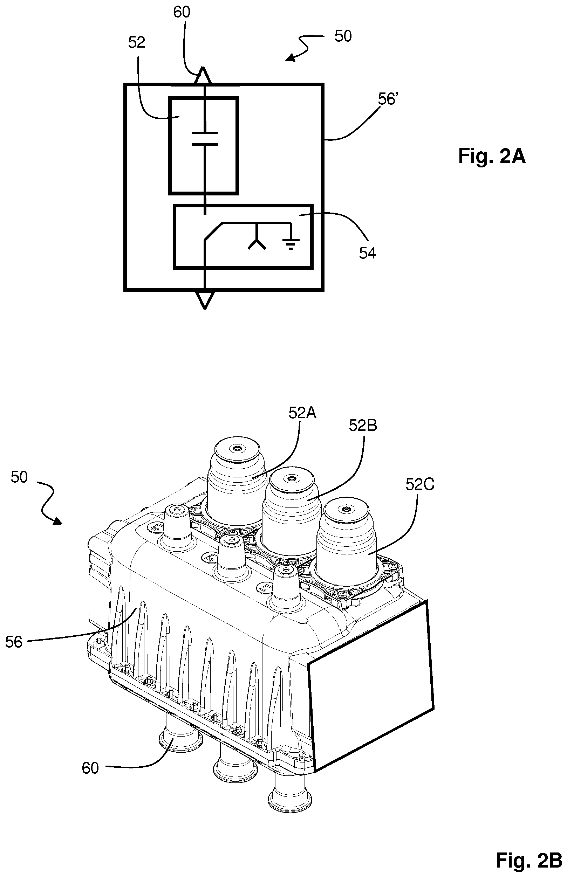

Dans le mode de réalisation préférée de l'invention, les appareillages de coupure 50A, 50B, 50C sont identiques pour chaque phase et conformes à des cellules telles que décrites dans le document FR 2 940 516. Notamment, tel qu'illustré en figure 2A, une cellule de coupure 50 comprend en série une ampoule à vide 52 réalisant la fonction de coupure et de sectionnement et un sélecteur à deux positions 54, qui peut prendre une position de service autorisant le passage du courant et une position de mise à la terre (alternativement, le sélecteur 54 pourrait prendre une troisième position facultative d'ouverture). La mise en série du sélecteur de mise à la terre 54 permet d'assurer le sectionnement par une cellule de dimensions réduites et en l'absence d'hexafluorure de soufre à effet de serre, y comprise en cas de défaillance ultérieure de l'ampoule à vide 52.

Dans un mode de réalisation avantageux, le sélecteur 54 est logé dans une enveloppe 56 de confinement. Différentes options sont possibles : tel qu'illustré schématiquement en figure 2A, l'enveloppe 56' loge tous les éléments 52, 54 d'une cellule de coupure 50 ; il est possible que les trois cellules 50A, 50B, 50C d'un même bloc 5 soient unitaires dans une même enveloppe. Dans le mode de réalisation préféré illustré en figure 2B, les trois sélecteurs 54 d'un bloc fonctionnel 10, 20, 30 sont logés dans une même enceinte unitaire 56 ; les ampoules à vide 52A, 52B, 52C qui leur sont reliées restent externes à ladite enveloppe 56, tout en lui étant solidarisée de façon hermétique, de sorte à former un ensemble 50 dont aucun élément n'est dans l'air hormis les bornes de raccordement 60. D'autres alternatives sont possibles.

Tel que précisé précédemment, le poste de distribution 1 comprend une pluralité d'unités fonctionnelles 4, plusieurs d'entre elles 10, 20, 30 pouvant comprendre des cellules de coupure 50. En particulier, dans le mode de réalisation illustré, on note que deux arrivées 2₁, 2₂ de courant sont reliées au poste 1, configuration typique d'un réseau en boucle ouverte ou en double-dérivation. Chacune des arrivées 2₁, 2₂ est associée à une cellule 50₁, 50₂ faisant fonction d'interrupteur afin d'isoler le circuit du courant nominal : les trois pôles 50A, 50B, 50C connectés aux trois conducteurs de chaque arrivée 2 sont logée dans la même enveloppe 12 d'un bloc de coupure 10.

Les deux lignes d'arrivée sont ensuite reliées au niveau du jeu de barres, pour être raccordées à un disjoncteur général, mis en place dans l'unité adjacente afin d'assurer la protection du tableau en coupant les courants de court-circuit. De préférence, l'appareillage de coupure 50g du bloc disjoncteur général 20 est similaire sur le principe à l'appareillage 50₁, 50₂ interrupteur des modules d'entrée 10.

Après le module de disjoncteur général 20, la ligne commune continue de circuler vers d'autres unités fonctionnelles 4, en fonction des besoins, pour notamment aboutir à plusieurs départs 3₁, 3₂ permettant d'alimenter des charges définies par l'utilisateur, chaque départ 3 étant associé à un bloc disjoncteur de protection transformateur 30, ayant pour but de couper les éventuels défauts issus des transformateurs MT/BT en aval du poste 1. Ici encore, l'appareillage de coupure 50 du bloc 30 peut être de principe similaire aux précédents. De fait, le mode de réalisation préféré des cellules de coupure 50 permet de remplir les différentes fonctions avec des appareillages identiques, avec modification de quelques paramètres, et notamment uniquement du matériau de fabrication des pastilles de contact de l'ampoule à vide 52.

Bien qu'une telle modularité diminue le nombre de références industrielles et facilite la mise en place du poste 1, elle reste tributaire des connexions entre les unités 4, dont il apparaît rapidement qu'elles peuvent devenir complexes à gérer, et en outre nécessiter de la place. Pour des raisons de compacité, mais surtout pour simplifier les raccordements entre les appareillages électriques, selon l'invention, les connexions sont assurées par l'intermédiaire de barres 100 à interface plane, dont le principe et un mode de réalisation sont décrits notamment dans le document EP 2 063 495.

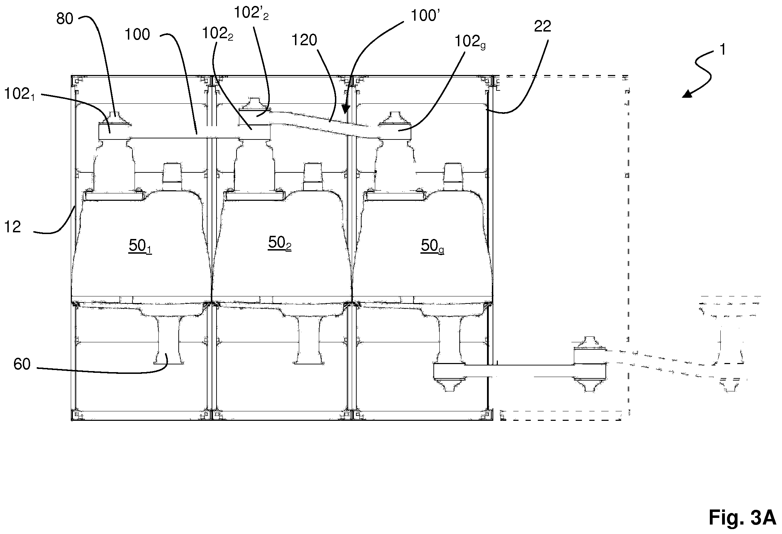

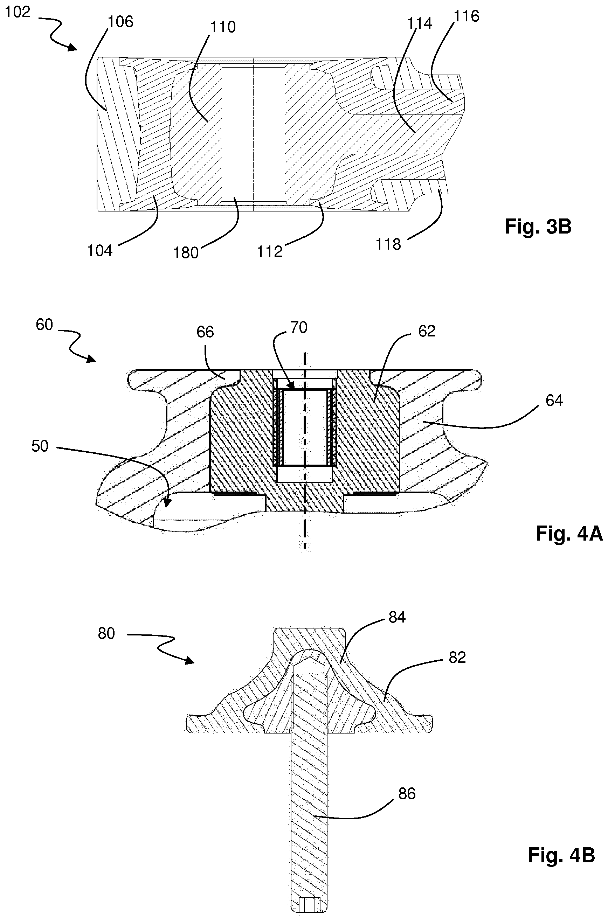

En particulier, tel qu'illustré en figures 3, une barre 100 relie deux cellules 50₁, 50₂, 50_{g} de blocs 10₁, 10₂, 20 par l'intermédiaire de dispositifs de raccordement 102 disposés à chacune de ses extrémités et formés principalement par un support 104 en matériau isolant, avec deux surfaces opposées destinées au raccordement, qui sont sensiblement planes, parallèles l'une à l'autre, circulaires (forme la plus adaptée pour gérer les différents phénomènes diélectriques et optimiser l'orientation des empilements) et superposables de sorte que la barre 100 peut être utilisée sans orientation préférée. De manière générale, la barre 100 est symétrique et les dispositifs de raccordement 102 sont identiques, leurs surfaces de raccordement étant parallèles entre elles.

Le support isolant 104, à l'exception des surfaces de raccordement, est revêtu d'une couche 106 conductrice ou semi-conductrice, dont l'épaisseur est déterminée en fonction de sa résistivité de façon à obtenir un revêtement 106 suffisant pour assurer un blindage électrostatique de l'ensemble : le maintien du champ électrique à l'intérieur du support isolant 104 permet d'augmenter la compacité des raccordements effectués par une barre 100 munie d'un tel dispositif 102.

Le dispositif de raccordement 102 comprend un insert de connexion 110 de forte conductivité électrique, usuellement en cuivre ou en aluminium, qui traverse le dispositif de raccordement 102 dans son épaisseur, entre deux surfaces de connexion planes et parallèles qui sont accessibles de chaque côté du support isolant 104. L'insert de connexion 110 est centré au sein du support isolant 104, et symétrique de révolution afin de maîtriser au mieux les contraintes diélectriques. Pour optimiser la tenue diélectrique, l'insert de connexion 110 est intégré au support isolant 104, et notamment le matériau isolant est surmoulé sur l'insert 110 de sorte que l'interface entre les deux composés 104, 110 soit maîtrisée et exempte d'espaces vides (ou remplis d'air) ; pour les mêmes raisons, l'insert de connexion 110 comprend un renflement au sein du support isolant 104, son diamètre central étant ainsi supérieur au diamètre des surfaces de connexion au niveau desquelles le matériau isolant forme un col, ou un goulot, 112 autour de l'insert afin de réduire le champ électrique au niveau du point triple de l'interface côté insert : l'insert conducteur 110 est en quelque sorte enrobé dans le matériau isolant 104.

Les dispositifs de raccordement 102 d'une même barre 100 sont reliés entre eux par une tige 114 de forte conductivité électrique unitaire avec l'insert de connexion 110, et dimensionnée en fonction du courant y transitant. La tige 114 n'est pas compressible, mais pour assurer une certaine souplesse correspondant à une tolérance dans le positionnement relatif des dispositifs de raccordement 102 dans le sens de la connexion (orthogonal aux surfaces de raccordement et de connexion), la section de la tige 114 est « aplatie », de forme oblongue.

La tige de liaison conductrice 114 est elle aussi intégrée à ses extrémités dans l'isolant 104 du dispositif de raccordement 102 ; sur le reste de sa longueur, la partie résiduelle correspondant à la longueur apparente de la tige 114 est revêtue d'un isolant 116 qui assure une tenue diélectrique suffisante. Pour restreindre l'encombrement nécessaire autour de la barre 100, un blindage électrostatique 118 de la partie résiduelle est mis en place. De fait, l'ensemble des composants isolants 104, 116 de la barre de connexion 100 est réalisé en une étape sur l'ensemble des éléments conducteurs 110, 114 ; de même, le blindage 106, 118 est unitaire.

Tel qu'illustré en figure 3A, il est avantageux de disposer de deux géométries pour les barres 100, 100', avec notamment une barre 100 dont les dispositifs de raccordement 102₁, 102₂ sont coplanaires, et une barre 100' dans laquelle les deux dispositifs 102'₂, 102'_{g} sont décalés l'un de l'autre, dans le sens orthogonal à leur surface, de la hauteur d'un insert 110. Ceci permet de compenser les dénivelés dus à la mise en série de deux barres 100, 100' pour raccorder successivement trois cellules 50₁, 50₂, 50_{g}. Avantageusement, le décalage est réalisé par la mise en forme d'un palier 120 sur une barre 100', le palier 120 étant de préférence réalisé sur la moitié de la longueur de la tige 114 et centré.

Pour éviter les amorçages lors du raccordement électrique et assurer un contact étanche entre les dispositifs de raccordement 102, 102' superposés des deux barres 100, 100', le matériau isolant des supports 104 est déformable, et notamment son épaisseur peut être diminuée par écrasement orthogonal entre les deux faces opposées. En particulier, le support 104 est obtenu par moulage d'un élastomère dont les qualités diélectriques sont connues et optimisées, notamment un polymère d'éthylène-propylène-diène ou EPDM (pour : « *Ethylene-Propylene Diene Monomer rubber* »), ou par du silicone. Ainsi, en ce qui concerne une fabrication préférée d'une barre 100, le coeur conducteur (inserts + tige) 110, 114 est d'abord réalisé, notamment en aluminium pour 630 A ou en cuivre pour 1250 A, par les techniques existantes, par exemple par matriçage ou par moulage. Cet ensemble est surmoulé avec un isolant 104, 116 de type élastomère EPDM, avec avantageusement présence d'un agent d'adhérisation, pour assurer une interface cohésive et sans défaut entre coeur conducteur et revêtement isolant. Le blindage 106, 118 peut être réalisé, par exemple sur une surface externe ébavurée, par un surmoulage avec un élastomère de même type mais chargé de particules conductrices, ce qui permet de conserver les mêmes propriétés de déformation sur l'ensemble du dispositif de raccordement 102, entre corps isolant 104 et blindage 106.

La hauteur de l'insert conducteur 110, définie par la distance entre ses deux surfaces de connexion, est donc inférieure à l'épaisseur du support isolant 104 au repos ; une compression orthogonale du support isolant 104 peut rapprocher les surfaces de raccordement du support 104 pour que leur écartement soit égal à ladite hauteur : en usage, les surfaces isolantes sont mises en contact, une déformation est assurée jusqu'à ce que les surfaces de connexion conductrices de l'insert 110 soient en contact l'une avec l'autre, et l'assemblage est maintenu dans cette position par des moyens de serrage tant que le raccordement électrique est souhaité.

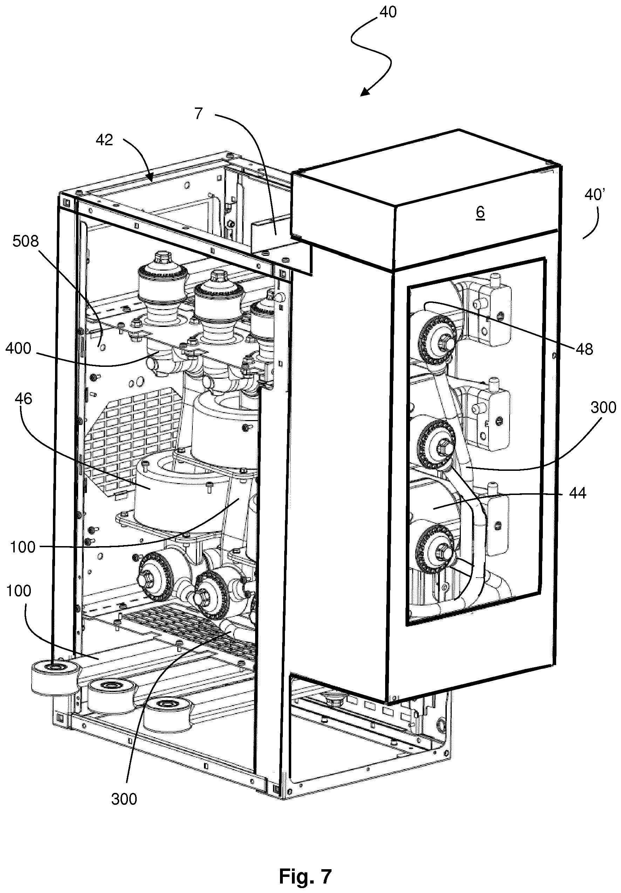

La taille du support isolant 104, ainsi que l'épaisseur du goulot 112, dépend de la taille de l'insert conducteur 110, elle-même déterminée par le niveau du courant qui y circule, et des contraintes électromécaniques ; les dimensions de la tige 114 sont elles aussi déterminées par la nature du matériau conducteur utilisé et par le courant y circulant. Notamment, pour un poste 1 selon un mode de réalisation préféré, les dimensions préconisées pour les dispositifs de raccordement 102 sont : un diamètre de 84 mm pour une hauteur de 42 mm de matériau souple 104 pouvant se comprimer à une hauteur de 38 mm d'insert 110 en aluminium. Une telle barre peut être de préférence unique pour les postes de 17 et 24 kV, ce qui permet d'optimiser la gestion des stocks en diminuant le nombre de références industrielles. Selon un mode de réalisation préféré, la longueur des barres 100 entre deux dispositifs de raccordement 102₁, 102₂ (prise d'insert à insert 110) correspondant à la largeur d'une unité fonctionnelle 4 est équivalente à la hauteur d'une cellule de coupure 50, prise de borne à borne 60, soit égale à 375 mm, afin de permettre de « remplacer » un bloc 5 par une barre 100 (voir plus loin et figures 1 et 7).

Comme le dispositif de raccordement 102 d'une barre 100 est destiné à se connecter sur une borne 60 d'un appareillage électrique, et comme la simplicité d'assemblage implique deux faces opposées des dispositifs de raccordement 102 des barres 100 identiques, les bornes 60 des cellules de coupure 50 sont adaptées, avec notamment un « aplatissement » pour aboutir à une interface plane. En particulier, tel qu'illustré en figure 4A, la borne 60 comprend, de façon similaire au dispositif de raccordement 102, un insert de connexion 62 centré dans un support isolant 64, les surfaces de contact de l'insert 62 et du support 64 étant superposables aux surfaces correspondantes 110, 104 du dispositif de raccordement 102 d'une barre 100. La borne 60, de préférence blindée, est principalement composée d'un matériau isolant surmoulé sur l'insert 62, et forme avantageusement un goulot 66 sous la surface de contact qui optimise les caractéristiques diélectriques. Dans un mode de réalisation préféré, la borne est blindée et fait saillie de la cellule 50 sur une hauteur de l'ordre de 30 mm. Le matériau isolant 64 de la borne est de préférence non déformable, la surface de la borne 60 étant un disque plan et adapté pour le contact et la compression avec un dispositif de raccordement 102 d'une barre 100.

Pour assurer le maintien en position « compressée » des dispositifs de raccordement, des moyens de serrage sont prévus. Avantageusement, le dispositif de serrage 80, outre l'assurance de la compression et le maintien en position serrée de l'assemblage, permet d'assurer l'isolation de la surface du dispositif de raccordement 102 qui reste libre (opposée à la surface de connexion électrique). En particulier, un dispositif de serrage 80 comprend une surface plane de taille au moins égale à la surface de raccordement et forme un couvercle isolant dont la forme est optimisée pour la tenue diélectrique. Pour assurer une étanchéité et une protection maximale contre les amorçages, le matériau 82 du dispositif de serrage et d'obturation 80 est non déformable, notamment par exemple un matériau polymère de type thermodurcissable, voire thermoplastique, de préférence époxy ; un revêtement métallique 84 protège ce matériau et assure la continuité du blindage. La forme externe du dispositif 80 peut être adaptée pour inclure des auxiliaires, par exemple un capteur pour un système détecteur de tension VDS (« *Voltage Detector Sensor* ») ou indicateur de la présence de tension (ou VPIS : « *Voltage Presence Indicator Sensor* »).

Pour permettre une mise en place et un serrage aisés, le dispositif d'obturation et de serrage 80 comprend un moyen de liaison 86 qui peut coopérer avec les dispositifs de raccordement 102. En particulier, un boulon ou goujon 86 fait saillie au centre de la surface plane du dispositif de serrage 80, et vient coopérer avec un orifice 180 percé au centre de l'insert de connexion 110 du dispositif de raccordement 102. L'orifice 180 peut être taraudé, mais de préférence, il est de diamètre supérieur à celui du goujon 86 qui se serre de l'autre côté de l'ensemble raccordé, notamment directement dans la borne 60 qui comprend l'orifice taraudé 70 adapté.

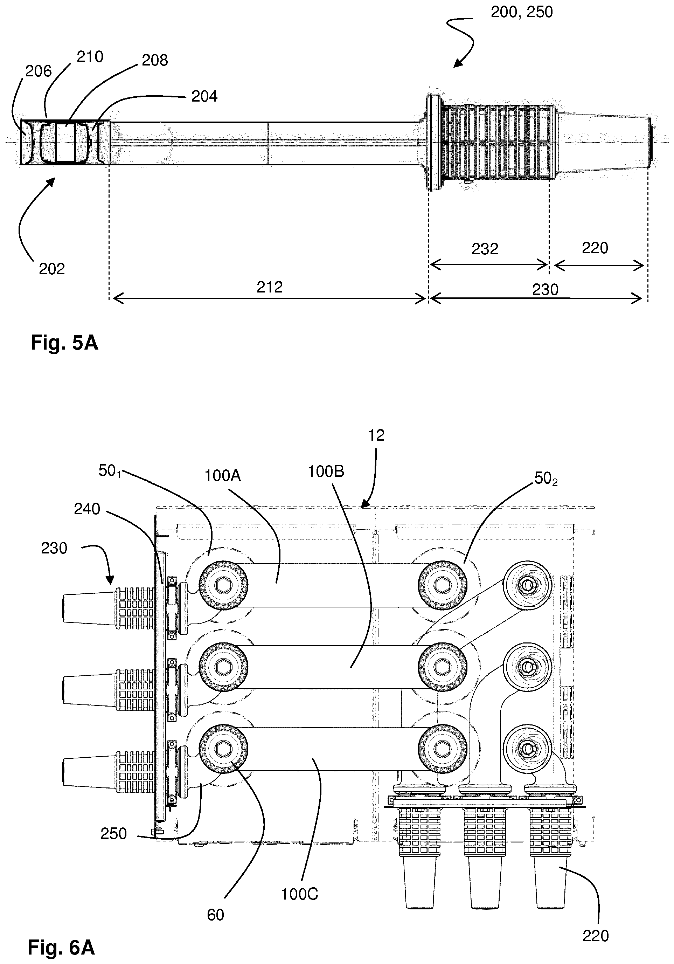

Tel que présenté plus haut, les blocs 10, 20, 30 de coupure du poste de distribution 1 comprennent chacun trois pôles de coupure 52A, 52B, 52C, pour chacune des phases d'alimentation. Pour des raisons de compacité, il est préféré que les cellules 50 d'une unité fonctionnelle 4 soient alignées dans le sens de la profondeur de l'enveloppe 12. Ainsi, les barres 100A, 100B, 100C reliant entre elles deux cellules de coupure de deux modules adjacents sont parallèles entre elles et à la face avant du poste 1, et sont essentiellement droites, sans coude ou déport important (voir aussi figure 6A). Cette configuration permet une meilleure visibilité en cas de maintenance et pour la mise en place, ainsi qu'un encombrement restreint du poste.

Le raccordement de l'arrivée du réseau 2 et/ou vers le départ 3 de l'utilisateur est réalisé de manière usuelle par des interfaces à cône externe, principalement de type A, B ou C, voire autre, selon la norme EN 50181, c'est-à-dire des embouts faisant saillie vers l'extérieur de l'enveloppe 12 des blocs 10, 30, celles-ci restant usuellement fermées une fois le poste 1 installé. Ce type d'embout a notamment un profil partiellement standardisé, formé d'une portion de cône, par exemple de longueur 90 mm et de diamètres 46/56 mm pour le type C, sur laquelle s'embroche le connecteur séparable adapté dont est munie l'extrémité des câbles 2, 3.

Pour une utilisation optimale dans un poste selon l'invention, l'embout est localisé à une extrémité d'un connecteur 200 illustré en figures 5A, et servant d'interface entre les appareillages 50 des unités 5 et le réseau 2, 3 de l'utilisateur. La deuxième extrémité du connecteur 200, en forme de corne dans le mode représenté, est ainsi munie d'un dispositif de raccordement 202 qui peut se mettre en place sur une borne 60 d'une cellule de coupure 50 et/ou un dispositif de raccordement 102 d'une barre 100. Avantageusement, le dispositif de raccordement 202 d'un connecteur 200 est identique au dispositif de raccordement 102 d'une barre 100 précédemment décrit, et comprend notamment un support isolant 204 compressible en élastomère, recouvert d'un blindage électrostatique 206, et traversé par un insert conducteur 210 de longueur inférieure à l'épaisseur du support 204, dont les dimensions sont similaires à celles précédemment données, percé de préférence d'un orifice 208 permettant la mise en place d'un dispositif d'obturation et de serrage 80.

De la même façon, une partie de liaison 212 prolonge le dispositif de raccordement 202, avec une tige 214 solidaire de l'insert 210 en direction de l'embout de raccordement externe. Ici encore, la tige 214 et l'insert 210 sont unitaires, et le support isolant 204 surmoulé sur l'insert 210 est prolongé par le même isolant 216 autour de la tige 214, qui est de préférence de section oblongue pour permettre de compenser de façon aisée des éventuels écarts d'alignement. Un blindage 218 est mis en place.

A l'autre extrémité de la tige 214 et de son enrobage 216, la corne 200 comprend un embout de raccordement 220. Tel que présenté précédemment, l'embout 220 a une forme externe standardisée. Actuellement, ce type d'embout est réalisé en matériau thermoplastique, afin de pouvoir facilement procéder au débrochage ; cependant, comme le connecteur 200 selon un mode de réalisation préféré de l'invention comprend un surmoulage souple 216 autour de la tige conductrice 214, le surmoulage du coeur conducteur par un matériau thermodurcissable impliquerait la réalisation de la corne 200 en deux pièces distinctes, générant des interfaces supplémentaires, sans oublier la complexité et le coût d'une telle fabrication.

A l'inverse, l'utilisation d'un embout 220 fabriqué sur le modèle du dispositif de raccordement 202, à savoir avec une surface externe compressible, n'est pas souhaitable. En effet, il est impératif que le raccordement sur l'embout 220 puisse être rompu de façon classique, par débrochage, sur la durée de vie du poste de distribution 1, à savoir de l'ordre de 40 ans en exploitation usuelle. Or, le raccordement d'un câble embroché sur un cône souple, outre les problèmes dus au coefficient important de frottement, fait apparaître des phénomènes de collages liés à la présence d'une interface élastomère/élastomère entre le connecteur séparable du câble et le support d'embrochage de la traversée. Ces phénomènes de collage peuvent entraîner pour des gros calibres des efforts supérieurs à 90 daN pour extraire le câble, efforts considérés par la norme comme correspondant à une non-débrochabilité.

Selon le mode de réalisation préféré, le connecteur 200 est réalisé par une pièce monobloc qui comprend la mise en place d'une coque rigide 222 pour l'embout de débrochage 220, la prolongation de l'insert métallique par un conducteur de courant 224 au sein de la coque 222 et débouchant pour le raccordement, ainsi que la conservation d'un support élastomère 226 entre la coque 222 et le conducteur de courant 224, ledit support élastomère 226 prolongeant celui 204 du dispositif de raccordement 202 qui permet la connexion de la corne 200 par simple pression sur une barre 100 et/ou borne 60 telles que précédemment décrites.

La coque 222 est de préférence en matériau thermoplastique, notamment du polyamide 6 chargé de fibres de verre ; l'ensemble conducteur 210, 214, 224 de la corne 200 est fabriqué de façon unitaire, dans le mode de réalisation préféré en aluminium, avec un orifice standardisé, éventuellement taraudé, 228 à l'extrémité dans la coque 222 suivant le type d'embout normalisé réalisé. Entre la coque 222 et son insert conducteur 224 est disposé l'élastomère isolant 226, en prolongement du support 204, 216 du dispositif de raccordement 202 et de la partie de liaison 212, et unitaire avec lui. Pour éviter de rapporter un manchon rigide autour de l'élastomère, il est préféré de procéder à l'injection de l'élastomère souple 204, 216, 226 autour du conducteur 210, 214, 224 mais au sein de la coque 222 préalablement mise en place. Afin de permettre cette injection sur toute la surface interne de la coque 222 et chasser l'air qui pourrait rester dans ce volume étroit, la forme des éléments est choisie de façon précise.

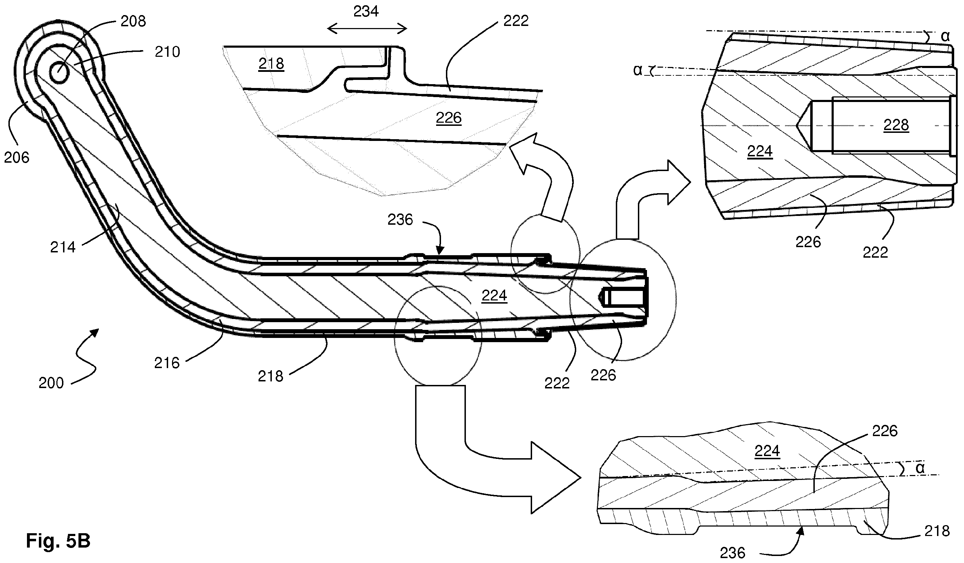

En particulier, dans un mode de réalisation préféré illustré en figure 5B, la forme de l'insert métallique 224 au niveau de l'embout client est modifiée, de façon à être tronconique de même pente sensiblement que la pente imposée à la coque 222 par la norme. Par exemple, pour un embout de type C, la pente externe α formant le cône est égale à 3° : au niveau de la coque 222 avantageusement d'épaisseur constante, comprise entre 2 et 5 mm (épaisseur suffisante pour assurer la rigidité relative nécessaire à un embrochage aisé des câbles d'arrivée et de départ 2, 3), l'insert 224 prend cette pente α. L'épaisseur de surmoulage en élastomère reste ainsi constante, de préférence supérieure à 5 mm, par exemple de l'ordre de 6 mm, ce qui permet un écoulement et surtout une vulcanisation aisés et donc l'absence de formation de bulles à l'intérieur de l'isolant ou aux interfaces entre matériaux. Comme pour le dispositif de raccordement, les interfaces entre l'isolant déformable et la coque, respectivement l'insert, sont étanches.

La longueur de la partie tronconique de l'insert conducteur 224 est supérieure à la longueur de la partie d'embout 220 : de fait, la partie d'embout 220 est destinée directement à la mise en place du raccordement de câble, mais la partie de connecteur 200 faisant saillie de l'enveloppe du poste 1 est plus longue. Avantageusement, l'insert conducteur 224 est tronconique sur toute la portion 230 de connecteur venant à l'extérieur du poste et servant au montage, en particulier pour résister aux efforts pouvant s'exercer à la jonction entre l'embout 220 horizontal de connexion et la paroi verticale de l'enveloppe, avec ainsi une épaisseur maximale de métal qui permet de supporter les efforts mécaniques à ce niveau. Sur cette partie de maintien 232 prolongeant l'embout 220, bien qu'il soit possible de prolonger la coque 222, il est préféré de surmouler directement l'insert 224 par l'isolant 226, sans protection rigide. Avantageusement, afin de simplifier le processus de fabrication, l'épaisseur de surmoulage est conservée à ce niveau.

Une fois l'ensemble coeur conducteur + élastomère + coque réalisé, un blindage de l'élastomère « libre », c'est-à-dire non enfermé dans la coque 222, est réalisé. Notamment, le blindage est réalisé par un surmoulage 218 par le même élastomère que le support isolant 216, mais chargé de particules conductrices, et identique à celui de la partie de liaison 212. Pour permettre une unité dans le connecteur 200, la forme de la coque 222 est optimisée au niveau de sa jonction 234 avec la partie de maintien 232. En particulier, tel qu'illustré, si l'épaisseur de la coque 222 est constante sur la longueur d'embout 220, son extrémité est formé avec une forme d'encoche permettant l'inclusion d'une partie de coque rigide 222 à l'intérieur d'une épaisseur d'isolant 226 ; de préférence, le surmoulage de blindage 218 vient lui aussi autour de cette partie d'extrémité pour former quatre couches sur la portion de jonction 234 illustrée en figure 5B, afin notamment de réduire le champ électrique dans la zone d'arrêt du blindage.

Il est possible de mettre en place un blindage 218 d'épaisseur constante autour de la partie de maintien 232, à l'exception bien entendu de l'extrémité autour de la coque 222. Cependant, dans un mode de réalisation avantageux, une portion de la partie de maintien 232 est associée à des éléments permettant la fixation sur l'enveloppe du poste 1, et il est préférable de prévoir un logement 236 pour ces éléments. Ainsi, tel qu'illustré, sur une longueur de 45 à 50 mm, la surface externe de la partie de maintien 232 est de diamètre constant, inférieur aux diamètres l'entourant, pour former une gorge annulaire 236 sur laquelle il est possible de coupler un élément rigide 240 apte à être solidarisé à la paroi des unités fonctionnelles 4, comme une tôle.

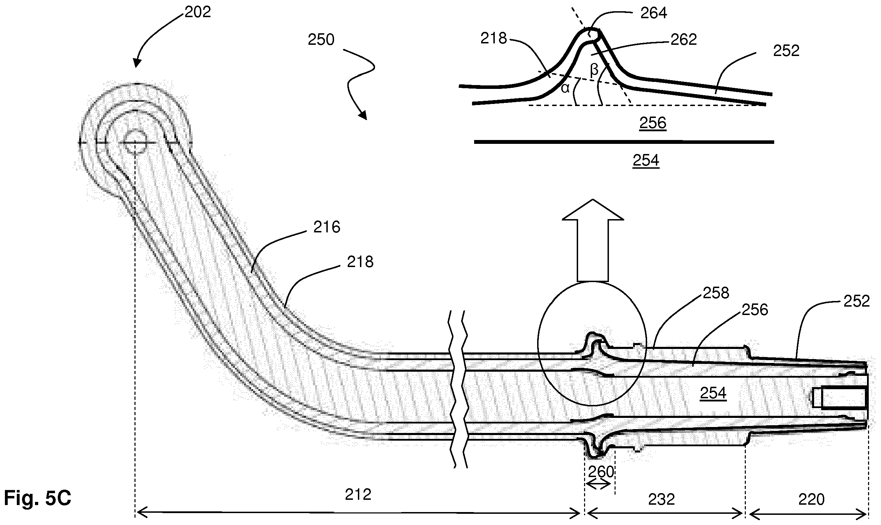

Alternativement, notamment pour certains embouts 220 normalisés moins fréquents, la fabrication d'inserts 224 à extrémité tronconique peut s'avérer très coûteuse, d'autant que le moule d'injection devrait également être modifié pour garder l'épaisseur constante. Il peut alors être préféré de modifier le connecteur 250 et d'utiliser un insert 254 plus classique, à extrémité cylindrique de révolution jusqu'à son extrémité, illustré en figure 5C. Dans ce cas, pour fluidifier le remplissage de l'espace entre coque 252 et insert 254, il est préconisé d'avoir une épaisseur de gradient croissant de surmoulage isolant 256 entre l'extrémité de l'embout 220 et la partie de maintien 232 ; avantageusement, la coque 252 conserve son épaisseur constante, et la pente α définie par la norme est conservée pour l'épaisseur de surmoulage.

Dans ce cadre, l'insert 254 reste de diamètre réduit dans la partie de maintien 232. Afin de reprendre les efforts mécaniques, il est préconisé que la coque rigide 252 soit prolongée également autour de la partie de maintien 232 ; de préférence, l'épaisseur de la coque 252 y est conservée, et des renforts de type nervures 258 lui sont associés à l'extérieur ; d'autres solutions de renforcement peuvent être choisies comme un épaississement de la coque ou des renforts métalliques.

Tant pour des raisons de contrôle de champ électrique que pour permettre des interfaces étanches et un moulage dénué de bulles du matériau élastomère 256 entre la coque 222 et l'insert 254, sur une zone d'extrémité 260, la forme générale précitée n'est pas conservée. Notamment, la pente β interne de la coque 252 est augmentée, de façon à créer une sorte d'entonnoir 260 à ce niveau : sur une longueur de 19,5 mm, la pente est de l'ordre de 24°, avec ainsi une ouverture de la coque 252 au niveau de la partie de maintien 232 de 100 mm.

La corne 250 finale est ainsi obtenue par mise en place de la coque 252 autour d'un insert métallique 210, 214, 254 centré dans ladite coque 252, puis surmoulage autour de l'insert 210, 214, 254 et dans la coque 252. Au niveau de la zone d'extrémité de la coque 252, le surmoulage de l'élastomère 256 est adapté pour former un rebord 262, de sorte que l'isolant à ce niveau soit d'épaisseur maximale. L'épaisseur de surmoulage est de préférence constante autour du dispositif de raccordement 202 et de la tige 214 ; le blindage est prolongé sur le col 260 de la partie de liaison 212, pour recouvrir entièrement l'élastomère à ce niveau : le revêtement 218 de blindage forme un rebord 264 autour de la coque 252.

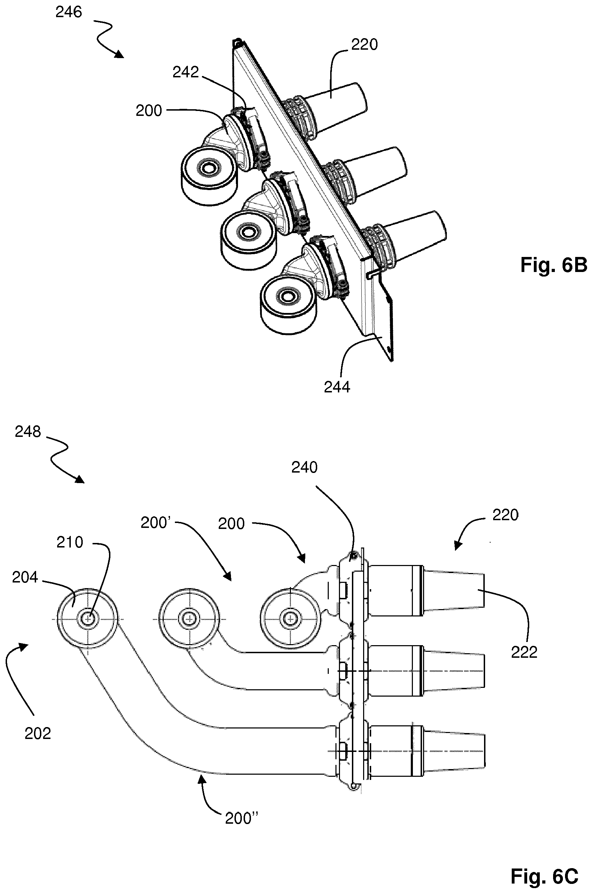

Un connecteur 200, 250 pour le mode de réalisation préféré de l'invention comprend ainsi quatre parties distinctes : un dispositif de raccordement 202 destiné à se mettre en contact avec un dispositif similaire, une partie de liaison 212 dont la surface externe est formée par le revêtement élastomère de blindage 218, une partie de maintien 232 dont la surface externe est formée par un plastique rigide métallisé 252 ou un revêtement élastomère de blindage 218 de diamètre externe supérieur à la partie de liaison 212, et un embout de raccordement 220 destiné à être inséré dans un embout adapté de câble 2, 3, de forme tronconique et revêtu de plastique 222, 252, dont la surface d'extrémité fait apparaître un élastomère 226, 256 enrobant un insert conducteur 224, 254 pouvant comporter un trou taraudé 228. Sur la partie de maintien 232 sont avantageusement solidarisés des moyens de montage 240, en particulier une bride de renfort 242 et une tôle 244 qui peut être solidarisée directement à la paroi d'une enveloppe de poste 1, de sorte à reprendre les efforts dus au couplage et à garantir une orientation constante de la partie protubérante 230 de raccordement (figures 6).

Ces connecteurs 200, 250 sont normalement associés directement sur les bornes 60 des cellules de coupure 50. Dans une géométrie *a priori* évidente de raccordement illustrée en figure 6A, les embouts de raccordement 220 sont localisés face aux cellules 50, ou légèrement décalés selon l'orientation de la corne 200, 250, sur une paroi latérale de l'unité fonctionnelle 10. En particulier, tel qu'illustré en figure 6B, les moyens de montage 240 peuvent solidariser entre elles trois cornes 200 afin de simplifier les montages et rigidifier la structure. Notamment, un système de bridage 242, par exemple métallique avec fixation de deux pièces complémentaires autour de la partie de préhension 232, complété par une tôle 244 munie des orifices adéquats, permet de se positionner et/ou de se fixer au sein de l'enveloppe 12 des unités fonctionnelles 4. Cet ensemble 246 peut alors être localisé en haut ou surtout en bas de la cellule 50 lorsque cette dernière comprend des bornes 60 symétriques.

Il apparaît cependant souhaitable de prévoir un accès frontal (ou arrière) pour les entrées et sorties 2, 3 : de fait, tel qu'également illustré en figure 1, la paroi latérale de certaines unités fonctionnelles 4 n'est pas accessible, comme par exemple pour la deuxième entrée 2₂ au bloc encadré par deux autres unités fonctionnelles 10₁, 20. Comme les cellules de coupure 50 sont alignées orthogonalement à la face de raccordement, et comme par ailleurs il est convenu que les trois connecteurs 200, 250 de câbles soient alignés horizontalement, les connecteurs 200, 250 selon le mode de réalisation préféré sont réalisés avec un coude afin de permettre une connexion frontale des pôles alignés dans la profondeur de l'unité fonctionnelle 4 ; au vu de la différence d'orientation, il convient par ailleurs que la longueur de la partie de liaison 212 des connecteurs soit variable, afin de permettre ce déport.

Afin de faciliter les différents types de raccordement, il est apparu que trois types de connecteur 200 sont suffisants, avec notamment une simple adaptation de la partie de liaison 212. Ainsi, tel qu'illustré en figure 6C, trois connecteurs 200, 200', 200" comprennent des parties de liaison 212 de longueur différente, notamment environ 60, 200 et 340 mm. Il est par ailleurs avantageux de prévoir ici aussi un élément de solidarisation de trois connecteurs 200, 200', 200" pour former un ensemble unitaire 248 qui peut être couplé directement aux bornes de trois appareillages alignés dans le sens de la profondeur du poste, et à une paroi frontale du même poste 1.

Ainsi, pour simplifier le montage des connecteurs dans un poste MT 1, un support 240 composé de deux éléments complémentaires venant entourer l'ensemble de trois connecteurs au niveau de logements prévus à cet effet, est mis en place autour des parties de maintien 232. On obtient un jeu de connecteurs 246, 248 comprenant trois embouts 220 normalisés alignés solidaires d'une tôle 244 et raccordés à trois interfaces de raccordement 202 elles aussi alignées, selon les cas parallèlement aux embouts ou orthogonalement, selon le même espacement. Pour coupler ce jeu de connecteurs 246, 248, il est avantageux que la paroi de réception de l'enveloppe 12 de l'unité fonctionnelle 4 comprenne des moyens de mise en place, notamment des ergots et/ou crochets dans lesquels la tôle 244 du jeu 246, 248 de connecteurs peut se loger. Une fois le jeu de connecteurs 200, 250 couplé à l'enveloppe, un serrage des interfaces de raccordement 202 sur les appareillages 50 du bloc fonctionnel 5 est réalisé, puis le couplage est complété par serrage sur l'enveloppe dudit bloc 1. Le montage est facile à réaliser, sans outils spécifiques, mais permet un alignement des embouts 220 et une rigidification de l'ensemble de sorte que les raccordements de câbles ne bougent pas et qu'un effort d'embrochage/débrochage sur les connecteurs ne sollicite pas indûment les connexions de l'unité fonctionnelle 4.

En particulier, dans le mode de réalisation préféré de poste 1, toutes les bornes 60 inférieures se trouvent à la même hauteur, juste sous le compartiment de commande 5' et dans le compartiment bas 8. De préférence, la hauteur des connecteurs 200 peut ainsi être constante, notamment à 700 mm du sol, afin de faciliter les opérations de montage et maintenance.

Par ailleurs, il est possible de retarder le choix de la paroi de raccordement client sur l'unité fonctionnelle 4, voire même de le modifier en cours de vie du poste 1, par exemple lors de l'ajout d'unités. A cette fin, il est prévu que plusieurs des parois de l'enveloppe des unités fonctionnelles 4 soient munies des moyens de mise en place du jeu de connecteurs 246, 248, et ce éventuellement à deux endroits, c'est-à-dire en haut d'appareillage 50 et en bas, à une hauteur finale de 700 mm (ou 500 mm dans certains cas) lorsque le bloc 5 est mis en place sur le compartiment inférieur 8. De préférence, les configurations suivantes sont prévues : face avant en bas, face arrière en haut et en bas, faces latérales en haut, configurations qui peuvent chacune être souhaitées in situ lors du montage du poste.

Bien entendu, les modes de réalisation sont donnés à titre indicatif, et des alternatives sont possibles, notamment dans la forme générale et la taille des différentes parties du connecteur, mais aussi dans les accessoires qui y sont solidarisés ou les matériaux utilisés, comme en ce qui concerne le blindage par revêtement conducteur mis à la terre. De même, les arrangements entre les éléments peuvent être modifiés.

Un poste de distribution 1 selon l'invention comprend en outre des moyens de mesure qui peuvent être divers. Notamment, tel que présenté plus haut, un tore de mesure ou un capteur de mesure de toute technologie peut être mis en place sur la partie de maintien 232 d'une corne de raccordement 200. Il est possible également d'utiliser un capteur tel que décrit dans le document EP 2 253 963 au niveau d'un dispositif de raccordement 102, 202.

Dans un mode de réalisation préféré, le poste 1 selon l'invention comprend un bloc fonctionnel 40 dédié notamment à la mesure ; tel que précisé plus haut, il est préféré que l'enveloppe 42 du bloc de mesure 40 ait les mêmes caractéristiques que les blocs de coupure, notamment en ce qui concerne ses dimensions et son architecture ; alternativement, il est possible de dimensionner le bloc de mesure 40 comme une association de plusieurs blocs de coupure 10 de sorte que sa largeur soit par exemple double des autres. Il est ainsi possible d'utiliser toujours le même type de barres de connexion 100 pour relier les unités 4 entre elles, et de ne requérir qu'une seule longueur de barre 100 pour le poste 1.

Un bloc de mesure 40, illustré en figure 7, pour poste MT 1 comprend de façon usuelle des moyens de mesure de tension 44, qui peuvent être de conception classique, mais avantageusement avec isolation solide blindée. Des capteurs de mesure de courant 46 peuvent également être prévus, eux aussi de conception classique, comprenant de préférence des tores traversés par les conducteurs de courant blindés. Les signaux représentatifs des paramètres mesurés sont, tel qu'usuel, transmis à une unité de contrôle qui est avantageusement dans le compartiment BT 6. Le nombre de moyens de mesure 44, 46 dépend bien entendu des données nécessaires à l'utilisateur et du traitement subséquent qui est prévu ; cependant, quels que soient les appareillages fonctionnels qu'il contient, le bloc de mesure 40 est de conception similaire, qui sera décrite à titre non limitatif pour une mesure de tension et une mesure de courant par phase, l'extrapolation aux autres configurations étant immédiate.

Tel que schématisé en figure 1, il est fréquent que les unités fonctionnelles de mesure 40 soient positionnées en coeur de poste 1, de sorte que les accès latéraux à l'intérieur de l'enveloppe 42 ne sont pas possibles ; de même l'accès arrière est complexe une fois le poste 1 installé. Il convient donc d'agencer les différents moyens de mesure 44, 46, et si possible leurs moyens de connexion, de façon à permettre un accès par la face frontale du poste 1 ou par le haut. Selon le mode de réalisation préféré, les transformateurs de tension 44 sont positionnés pour un accès direct par l'avant de l'enveloppe 42 ; en particulier, les bornes 48 d'arrivée des trois transformateurs 44 sont alignées, l'une en dessous de l'autre, directement derrière une porte de l'enveloppe 42 : l'ergonomie du poste de distribution 1 est fortement augmentée. De fait, en cas de maintenance, ou pour remplacer les capteurs 44, il est facile d'accéder aux bornes 48 ; de même, durant un essai de fréquence puissance, la déconnexion des capteurs 44 est facilitée. Pour permettre en outre un accès direct à chacun des capteurs de courant 46, ils sont localisés derrière l'alignement frontal, et de préférence selon un plan horizontal, avec ouverture possible correspondante du toit du poste 1. En particulier, les transformateurs de courant 46 peuvent être solidarisés entre eux, avec un entraxe identique à celui des cellules de coupure 50, pour permettre un raccordement via les barres de connexion 100 : le courant arrive de fait au bloc de mesure 40 via des barres de connexion 100 depuis le bloc adjacent 20.

Pour raccorder les capteurs de tension 44 aux arrivées de courant depuis les dispositifs de raccordement 102 des barres 100, il est avantageux de disposer de câbles 300 qui utilisent le même système par interface plane précédemment décrit. En particulier, selon un mode de réalisation préféré de l'invention, tous les raccordements internes au poste 1 sont blindés et réalisés de manière similaire, et un câble adapté 300 a été développé.

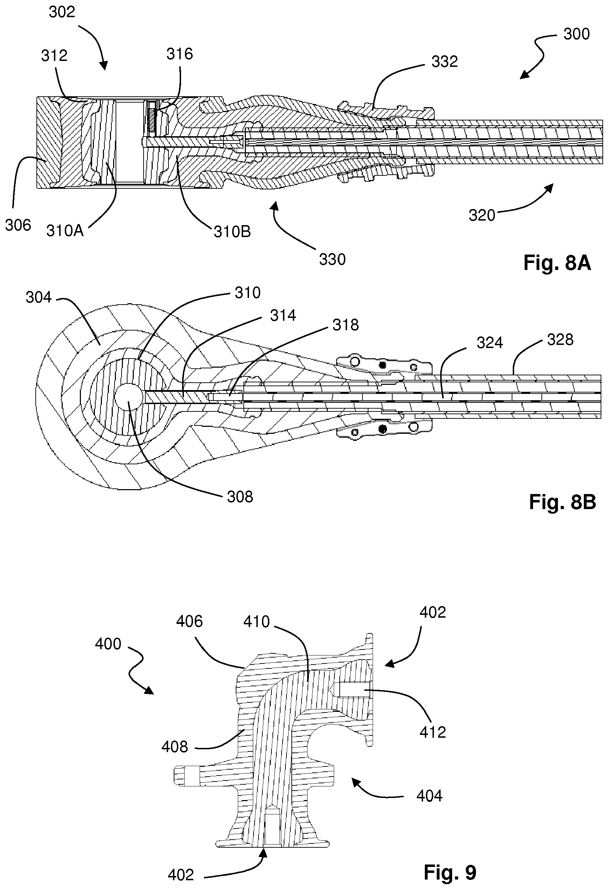

Le câble 300, illustré en figures 8, est muni d'un dispositif de raccordement 302 similaire aux dispositifs de raccordement 102, 202 des barres et connecteurs, avec un support isolant 304 en matériau déformable, notamment de l'EPDM, entouré à l'exception des surfaces de raccordement d'un blindage 306 avantageusement formé d'un surmoulage du même matériau chargé. Le matériau compressible est surmoulé autour un insert conducteur 310 de façon à ce que l'interface entre les deux soit étanche, exempte d'espaces libres, avec l'épaisseur du support 304, définie entre ses deux faces de raccordement opposées supérieure à la hauteur de l'insert conducteur 310, définie par la distance entre ses deux surfaces de connexion, au repos, et égale à cette dernière en position de serrage par compression orthogonale du support isolant 304.

Dans le cadre du câble 300, il convient de solidariser un conducteur filaire 320 à l'insert 310. Pour simplifier ce couplage, l'insert conducteur 310 est formé en deux parties : un coeur 310A central rigide comprenant les surfaces de connexion et percé d'un orifice 308 pour le passage des moyens de serrage 80, surmoulé par un élastomère conducteur 310B ; de préférence, le surmoulage conducteur 310B, de même nature que le support isolant 304 mais chargé, par exemple en carbone conducteur, est distant des surfaces de connexion de façon à ce que le matériau du support isolant 304 forme un goulot 312 à chaque extrémité pour ne laisser que le coeur conducteur 310A affleurer au niveau des surfaces de connexion.

L'insert conducteur 310 comprend une excroissance latérale 314 munie de moyens de raccordement du conducteur 320. En particulier, l'excroissance 314 est entourée par le même élastomère conducteur 310B, dans son prolongement ; couplée par des moyens adaptés, notamment un serrage 316, à l'insert 310, elle est percée d'un orifice 318 dans lequel est par exemple sertie l'extrémité du conducteur 320.

Tel qu'il est usuel, le conducteur 320 du câble est, dans sa plus grande longueur et à l'exception de l'extrémité couplée à l'excroissance de l'insert 310, enrobé d'un isolant 324, qui peut notamment être tri-couche ; en particulier, après l'extrémité dénudée, l'isolation 324 peut être étagée. L'isolant 324 du conducteur est à sa partie d'extrémité insérée, de préférence à force, dans l'orifice 318 de l'excroissance conductrice 314 pour assurer la tenue diélectrique. Sur sa plus grande longueur, le conducteur filaire 320 est par ailleurs recouvert par un revêtement de blindage 328, éventuellement recouvert d'une gaine de protection. Les dimensions du câble 300, et notamment sa flexibilité, sont déterminées en fonction de l'utilisation.

Sur la partie non gainée et non blindée du câble, l'assemblage conducteur 320 et dispositif de raccordement 302 est surmoulée par le matériau isolant, de façon unitaire avec le support 304, pour obtenir un manchon 330 duquel dépasse la longueur de câble revêtu d'isolant blindé. Ce manchon 330 est lui aussi revêtu du même revêtement de blindage 306 que le dispositif de raccordement 302. Avantageusement, des moyens de renfort de type collier 332 sont mis en place à la jonction entre les deux blindages.

Le raccordement aux autres unités fonctionnelles 4 du bloc de mesure 40 est donc assuré par trois barres de connexion 100 à interface plane, les trois barres 100 formant un plan horizontal de préférence en bas de bloc 40. Une dérivation des lignes de courant est réalisée pour alimenter des moyens de mesure de tension 44, qui sont quant à eux localisés à l'avant du bloc 40, l'un au dessus de l'autre dans un alignement vertical. Pour assurer la liaison, les moyens de mesure 44 sont couplés par des câbles dont une extrémité au moins comprend un dispositif de raccordement par interface plane 302 relié aux barres 100 et associés aux moyens de mesure 44. Avantageusement, le câble 300 est symétrique, avec deux dispositifs de raccordement 302 identiques ; les moyens de mesure de tension 44 sont adaptés, avec une borne de raccordement 48 similaire aux bornes 60 des cellules de coupure 50, et notamment avec un conducteur axial enrobé dans un support isolant qui est revêtu longitudinalement d'un blindage, de sorte que la surface de raccordement est un disque dans lequel est centrée une surface de connexion du conducteur. Ceci permet en outre de tirer parti au maximum des propriétés des moyens de mesure de tension 44, isolés et blindés, et de leur localisation.

Avantageusement, pour des raisons ergonomiques, les moyens de mesure de la tension 44 sont localisés dans un compartiment séparé 40' fonctionnellement du bloc de mesure 40 mais non cloisonnée pour des raisons normatives, par exemple de même profondeur que le compartiment de commande 5' des blocs de coupure 5. Ainsi l'ergonomie est-elle optimale. De plus, les lignes de puissance étant placées à l'arrière du logement 40' de mesure de tension, les capteurs 44 sont éloignés d'arcs électriques éventuels ; en particulier, les câbles 300, de part leur faible section, servent de fusibles. Inversement, en cas d'arc au niveau des capteurs de tension 44, les câbles 300 jouent également le rôle de fusible, empêchant à l'arc de se propager et au défaut de dégénérer en défaut triphasé. La sécurité du personnel d'intervention est accrue.

Tel que précisé plus haut, un câble 300 pourrait être raccordé directement sur une barre 100, mais aussi sur une borne 60 d'un appareillage 50. Cependant, au vu de la flexibilité requise, il est peu envisageable que sa section puisse permettre qu'il relie entre eux les appareillages 50 de deux unités fonctionnelles 5. De fait, avantageusement, les raccordements internes aux unités 4 préconisent l'utilisation des mêmes barres de connexion 100, rigides, qui permettent une meilleure organisation de l'intérieur des enveloppes tout en diminuant le nombre de références industrielles.

Notamment, pour relier deux cellules de coupure 20, 30 séparées par un bloc de mesure 40, il est possible d'associer deux barres côte à côte, tel qu'illustré en figure 3A. Lorsqu'il est préconisé de relier une borne 60 à une extrémité d'une cellule 50g à une borne à l'autre extrémité (figure 1), notamment en présence d'une unité fonctionnelle de mesure 40 comprenant des capteurs de courant 46, la barre 100 de dimensions adéquates peut être utilisée, avec des auxiliaires de raccordement 400 entre les dispositifs de raccordement 102 permettant la réorientation de la surface de raccordement, afin de relier les moyens de raccordement en haut et en bas de bloc 40. Cette configuration avec déport sur l'entrée de la cellule de coupure 50 du bloc 30 est particulièrement avantageuse pour mettre en place les capteurs de courant 46 autour d'une longueur de barre 100 de façon à accepter des tailles conséquentes de capteurs 46.

En particulier, selon un mode de réalisation préféré, le poste 1 selon l'invention est muni de coudes de raccordement 400 comprenant deux dispositifs 402 de raccordement raccordés par une partie de liaison 404 à angle droit, illustrés en figure 9, et de préférence blindés. Dans un mode de réalisation préféré, le coude 400 est formé dans une configuration similaire à celle des bornes 48, 60, c'est-à-dire en matériau de type epoxy 408 surmoulé autour d'un insert métallique 410 de taille adaptée et percé 412 pour permettre l'utilisation d'un dispositif d'obturation 80 assurant le serrage contre le dispositif de raccordement 102 d'une barre de raccordement 100. Alternativement, notamment lorsque le coude 400 doit être utilisé directement sur une borne 60 d'un appareillage électrique qui est elle-même constituée d'un matériau non déformable, l'isolant surmoulé autour de l'insert métallique 410 peut être en élastomère.

Ainsi, comme l'ensemble des connexions est isolé et blindé, le bloc de mesure 40 ne comprend que des éléments testés pour leurs performances diélectriques et remplissant notamment les standards normatifs de l'IEC. L'unité fonctionnelle de mesure 40 peut donc être considérée comme supprimant au maximum le risque d'arc interne, ce qui renforce la sécurité.

Bien que toutes les précautions soient prises, des arcs internes peuvent survenir dans les unités fonctionnelles 4 d'un poste MT 1. Le défaut d'arc interne est un court-circuit pouvant survenir dans un équipement électrique par perte de la rigidité diélectrique entre deux conducteurs au potentiel différent, ou entre un conducteur et la masse de l'équipement, dont les causes peuvent être consécutives à un échauffement de conducteurs, au vieillissement d'isolants, à l'oubli d'un outil entre deux conducteurs non isolés lors d'une maintenance, à l'entrée d'un animal dans un équipement sous tension, etc. D'une durée pouvant dépasser une seconde avant que les appareils de protection en amont ne déclenchent pour supprimer le court-circuit, ce défaut est rare, mais sa criticité impose d'en maîtriser les effets. De fait, l'arc interne comprend une première phase d'onde de choc de 0 à 5 ms dont les effets sont mécaniques, une deuxième phase de montée en pression (entre 5 et 30 ms) et une troisième phase d'expulsion des gaz, avec un dégagement thermique extrêmement important.

Si l'onde de choc cause des déformations mécaniques incontrôlées et des ruptures des éléments de fixation, le dégazage accentue encore les déformations mécaniques et l'affaiblissement des éléments de fixation. Ainsi, pour un poste moyenne tension 1, il convient d'anticiper les éventuelles détériorations des équipements, mais surtout de l'enveloppe fermée, à savoir : perte d'étanchéité ou perforation de l'enveloppe extérieure, rupture des fermetures de portes et panneaux et/ou des fixations mécaniques, sollicitation très forte de la structure de l'équipement, expulsion de pièces après rupture

Le poste MT 1 selon un mode de réalisation préféré de l'invention est conçu pour répartir et limiter la montée en pression ainsi que pour absorber l'énergie mécanique dégagée. En particulier, chaque unité fonctionnelle 4 du poste de distribution 1 est munie, sur sa face arrière, d'un compartiment supplémentaire 9 servant de cheminée de distribution des gaz ; son volume augmente le volume de l'unité fonctionnelle 4, mais surtout, la cheminée 9 permet la répartition des gaz de coupure au sein du poste 1, pour que les gaz puissent occuper un volume maximal de poste 1, sans endommager les équipements critiques. Les parois latérales de la cheminée 9 sont dotées de larges passages 500 ; les parois de séparation d'avec le bloc fonctionnel 5 sont limitées aux normes requises pour former les compartiments IP2x (« *Ingress Protection Rating* »), et sont munies là où elles sont pleines de clapets et/ou autres moyens d'ouverture rapide.

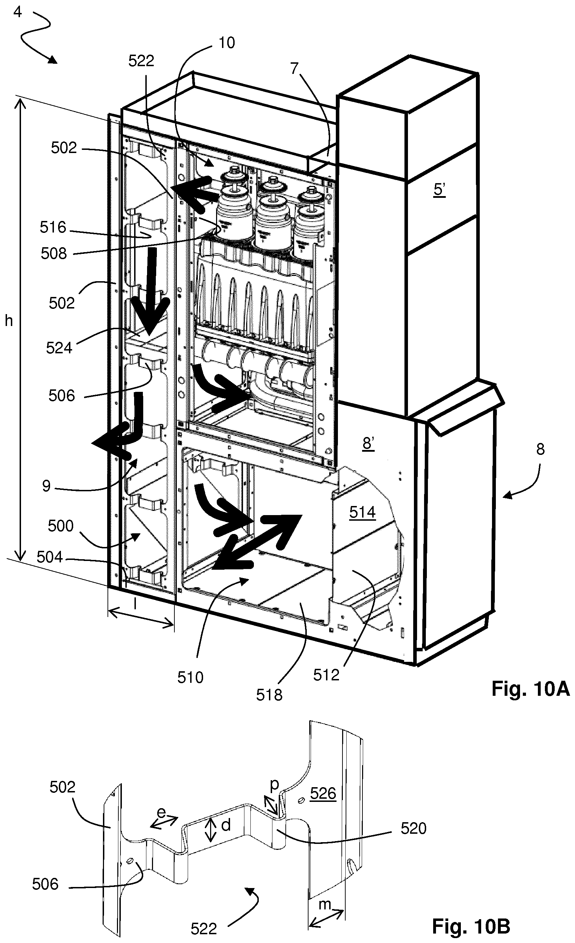

Tel qu'illustré en figure 10A, une cheminée 9 est formée à partir de montants 502 et de traverses 504 délimitant un parallélépipède rectangle sur lequel peuvent être solidarisés des panneaux formant parois ; de préférence, la cheminée 9 correspond à 15 à 30 % du volume de l'unité fonctionnelle 4. Dans le poste 1, avantageusement, les parois latérales de la cheminée 9 comprennent de larges espaces vides 500, séparés par traverses de soutien 506 réparties de façon avantageusement régulière ; la paroi de séparation interne au poste 1 quant à elle est de préférence munie d'une tôle 508, qui peut être percée. Ainsi, si un arc se produit dans une unité fonctionnelle 4, les gaz s'en échappent vers la cheminée 9 qui les répartit dans les cheminées avoisinantes.

Pour augmenter encore le volume de dégagement des gaz, et donc diminuer la pression générée par les gaz d'arc, le poste 1 selon l'invention tire parti de l'espace résiduel situé dans les compartiments bas 8 des unités fonctionnelles 4, espace utilisé pour le passage des câbles. De fait, grâce au système de connexion utilisé, il est possible d'organiser au mieux les raccordements et, selon un mode de réalisation préféré, les passages de câbles sont concentrés dans la partie avant 8' de l'unité fonctionnelle 4, en dessous du compartiment de commande 5' des blocs fonctionnels 5 où se trouve l'accès aux embouts de raccordement 220. La partie 510 localisée sous les appareillages électriques devient ainsi libre, et il est choisi de mettre ce deuxième logement en connexion directe avec la cheminée 9, de sorte que les gaz peuvent se répartir librement dans le volume complet de l'unité 4, à l'exception des compartiments 5', 8' commande et câble, protégés par des panneaux respectant le critère IP2x.

Le compartiment bas 8 est ainsi séparé en deux, avec une paroi de séparation 512 entre un logement avant 8' de passage des câbles, et un logement arrière 510 formant tunnel. Les logements arrière 510 des unités fonctionnelles 5 sont séparés l'un de l'autre par le minimum d'éléments obstruant, et notamment, il est avantageux que seuls les montants et traverses nécessaires au soutien du bloc fonctionnel 5 forment leurs parois latérales de séparation entre unités 4, tout comme pour la paroi de séparation avec la cheminée 9 : un tunnel 510 commun au poste, et qui peut représenter de 15 à 30 % du volume de l'enveloppe du poste 1, est ainsi créé, couplé au volume des cheminées 9. Les gaz peuvent donc se répartir dans un volume de poste augmenté de plus 25 ou 40 %, voire doublé, par rapport au simple volume des blocs fonctionnels 5. Par ailleurs, du fait des larges ouvertures entre le tunnel 510 et les cheminées 9, le gaz se dirige principalement dans ces volumes 9, 510 et pénètre dans les blocs fonctionnels 5 des unités autres que celle en défaut que de façon secondaire, moins brutale, ce qui permet de ne pas détériorer par un souffle les appareillages concernés, eux-mêmes conçus pour supporter la chaleur dégagée dans certains cas.

Il est avantageux de prévoir des clapets 514 d'évacuation entre le logement 8' avant de passage des câbles et le tunnel 510, afin d'autoriser une surpression éventuelle générée notamment par un arc dans le logement 8' à câbles à se répartir également dans le volume 9, 510 d'évacuation des gaz ; le passage inverse n'est pas favorisé.

La cheminée 9 peut en outre être dotée de moyens permettant une évacuation contrôlée des gaz générés. En particulier, un filtre 516 tel que décrit dans FR 2 839 817 et/ou un clapet permettant l'échappement peuvent être prévus, sur une paroi externe, notamment arrière ou sur le toit. Alternativement, dans certaines conditions, l'enveloppe du poste 1 et donc des cheminées 9 est étanche, avec présence d'un conduit d'évacuation des gaz aspirant les gaz lors de surpressions, par exemple creusé sous le tunnel 510 du poste 1 et accessible par un clapet 518. Grâce à la conception de l'appareil, le choix dans le système d'évacuation (direct ou via un ouvrage de génie civil, avec ou sans filtre, en haut ou en bas) peut être retardé, voire modifié, avec le poste 1.

Bien que le volume du poste soit, grâce au système précédent, fortement augmenté, pour limiter encore les dégâts potentiels dus à la surpression temporaire générée par certains arcs, les cheminées 9 sont dotées de moyens 520 permettant d'absorber au moins une partie de l'énergie mécanique. Notamment, tel qu'illustré en figure 10B, les traverses de soutien 506 des cheminées 9 sont dotées de moyens d'expansion dirigée formés par un pliage de tôle : la longueur étirée des dites traverses 506 est supérieure à la profondeur de la cheminée 9 et leur longueur visible lors du montage sur le poste 1.

Le poste MT 1 selon un mode de réalisation préféré comprend ainsi un dispositif mécanique 520 à déformation contrôlée pour absorber de l'énergie, qui permet en outre de donner un volume additionnel, dans le but de réduire la pression ; la déformation contrôlée permet également de maîtriser les contraintes mécaniques sur les composants et les éléments de fixation, en particulier les panneaux formant parois externes de l'enveloppe du poste 1, pour maintenir un bon niveau d'étanchéité et de contenir les gaz dans les conduits d'évacuation.

En particulier, les parois externes de la cheminée 9 qui sont internes au poste 1 font formées par une tôle 522 qui est munie d'ouvertures 500 sensiblement rectangulaires formant la majorité de sa surface, séparées par les traverses de soutien 506. Tel qu'illustré, les traverses 506 des cheminées 9 comprennent au moins un pliage 520 en V vers l'intérieur de la cheminée 9 qui sont dimensionnés et conçus pour se déformer dans la zone plastique du matériau ; de préférence, deux pliages sont mis en place afin de permettre une ouverture rapide de clapets de séparation 524 tout en optimisant le nombre d'opérations pour réaliser les V. En particulier, tous les pliages ont une profondeur p = 30 mm pour un écartement e = 25 mm, la largeur de la cheminée 9 étant de l'ordre 1 = 200 mm (ce qui correspond à une extension maximale de 25 % de ladite largeur).

Par ailleurs, étant donné que les panneaux externes du poste 1 doivent si possible rester en place de façon étanche y compris en cas d'arc et de déformation, les traverses 506 sont conçues pour diriger la déformation dudit panneau. Notamment, la largeur d des traverses 506 n'est pas constante sur la hauteur du poste, avec par exemple des traverses d'épaisseur supérieure en coeur de cheminée 9. De préférence, pour une hauteur h = 1350 mm, la répartition comprend une traverse centrale « fine » (25 < d < 30 mm, de préférence d = 28 mm), encadrée de deux traverses « épaisses » (35 < d < 45, de préférence d = 40 mm) elles-mêmes encadrées de traverses « fines » ; avantageusement, les traverses d'extrémité, qui se mettent en place au niveau des arêtes 504 de la cheminée 9, ont une épaisseur intermédiaire (par exemple 30 < d < 35, de préférence d = 34 mm), leur déformation devant être minime en cas de surpression.

Avantageusement, les traverses 306 sont mises en place au niveau des points de fixation sur le profilé d'enveloppe ; cependant, pour des raisons de conception, cette mise en place peut ne pas être possible. Il est alors avantageux de « décentrer » les ouvertures 500 de la paroi 522 concernée, de façon à avoir une rigidification au niveau de la partie interne de ladite paroi, ce qui permet de mieux répartir les efforts sur les traverses 506 ; en particulier, une partie pleine 526 d'épaisseur m = 30 mm est conservée sur un côté. La découpe des traverses 506 est par ailleurs réalisée en l'absence d'angles vifs, avec des arcs de cercle de liaison, dont les rayons sont optimisés, et peuvent différer selon la localisation de la traverse en hauteur.

Si la solution préconisée, avec tôle 522 découpée pour former la paroi latérale, permet de simplifier les montages et la gestion des stocks, une alternative peut consister en une solidarisation, notamment par soudage, de traverses 506 directement sur les montants 504 de la cheminée 9 ; dans ce cas, les traverses 506 peuvent ne pas être identiques, y compris en ce qui concerne leur répartition et le nombre de pliages, par exemple un, deux ou trois, voire la forme desdits pliages, au sein de la paroi. L'innovation concerne de fait une conception appropriée, en réalisant des parties déformables avec des sections variables permettant l'allongement en fonction des différents niveaux de pression, à intégrer et maîtriser les zones déformables dans la cellule pour limiter les contraintes sur la structure et les fixations : le dispositif 520 résout les déformations mécaniques aléatoires et non répétables de l'enveloppe dans les deux phases du défaut interne et améliore l'évacuation des gaz.

Le poste 1 selon l'invention est donc conçu pour résister aux arcs, et tous les appareillages et connectiques qu'il comprend le sont également ; en particulier, les connectiques sont blindées, comme les appareillages, ce qui limite encore la propagation d'arcs. De plus, pour optimiser les options de modularité, le poste 1 comprend avantageusement une seule technologie pour les différents dispositifs d'interruption de courant 50 : les caractéristiques techniques de la cellule de coupure 50 sont optimisées pour l'usage qui en est fait, mais le principe de fonctionnement reste identique, ce qui simplifie les opérations de maintenance et de suivi. De la même façon, tous les raccordements 48, 60, 100, 200, 300, 400 sont effectués sur le même principe, qui en outre est facile à visualiser et auquel il est aisé d'avoir accès. Tous les raccordements sont donc réalisés de manière identique et les éléments de connectique sont interchangeables : l'inversion de deux unités 4 est aisée, sans nécessiter de références supplémentaires pour la connectique.

Avantageusement, les dimensions sont uniformisées ; notamment, les cellules de coupure 50 sont de taille identique quel que soit leur paramétrage, la distance entre leurs bornes 60 étant compatible avec l'entraxe entre unités fonctionnelles 4 de sorte que les mêmes barres de connexion 100 peuvent être utilisées en position horizontale ou verticale. En particulier, pour cette restriction dans le nombre de références pour les barres de connexion 100, 100', la taille externe des unités fonctionnelles 4 est constante, à un facteur entier près. De plus, lorsque toutes les options sont prises, il est possible de changer l'endroit d'arrivée 220 des câbles externes à la dernière minute, voire alors que le poste a déjà été utilisé, et de rajouter des unités fonctionnelles 4 simplement, ou d'en extraire temporairement pour des raisons de maintenance par exemple. Par ailleurs, les arrivées de câbles sont réalisées toutes à la même hauteur.

## Revendications

1. Bloc fonctionnel de mesure (40) pour poste de distribution moyenne tension (1) comprenant une enveloppe (42) parallélépipédique rectangle, trois moyens de raccordement pour l'arrivée de courant, trois moyens de raccordement pour la sortie de courant, et des moyens de mesure de la tension (44), **caractérisé en ce que** :
- les moyens de raccordement à l'arrivée, respectivement à la sortie, sont alignés dans deux plans parallèles ;
- l'enveloppe (42) comprend un premier logement (40') pour les moyens de mesure de la tension (44), ledit compartiment (40') étant accessible directement depuis une face d'accès de l'enveloppe (42) orthogonale aux plans des moyens de raccordement ;
- les moyens de mesure de la tension (44) comprennent des bornes de raccordement (48) localisées dans un plan parallèle à la face d'accès ;
- les bornes de raccordement (48) des moyens de mesure (44) sont reliées aux moyens de raccordement du bloc (40) par l'intermédiaire de câbles flexibles (300).

2. Bloc fonctionnel selon la revendication 1 comprenant trois capteurs (44) de tension blindés dont les bornes (48) sont alignées orthogonalement au plan des moyens de raccordement.

3. Bloc fonctionnel selon l'une des revendications 1 ou 2 dans lequel les bornes (48) des moyens de mesure de la tension (44) comprennent un conducteur axial enrobé dans un support isolant qui est revêtu partiellement d'un blindage, de sorte que la surface de raccordement de la borne (48) est un disque dans lequel est centrée une surface de connexion du conducteur.

4. Bloc fonctionnel selon l'une des revendications 1 à 3 dans lequel les moyens de raccordement du bloc (40) comprennent un conducteur axial (110, 410) enrobé dans un support isolant (104, 404) qui est revêtu partiellement d'un blindage, de sorte que les moyens de raccordement forment une surface de raccordement composée d'un disque dans lequel est centrée une surface de connexion du conducteur.

5. Bloc fonctionnel selon l'une des revendications 3 ou 4 dans lequel le câble de raccordement (300) reliant une borne (48) des moyens de mesure de la tension (44) aux moyens de raccordement du bloc (40) est doté d'un dispositif de raccordement (302) qui comprend :
- un support (304) du matériau isolant délimité par deux surfaces de raccordement opposées sensiblement parallèles et superposables à un disque ;
- un insert de connexion conducteur (310) intégré dans le support isolant (304) et débouchant sur les deux surfaces de raccordement au niveau de deux surfaces de connexion planes parallèles superposables à la surface de connexion dudit disque, la hauteur de l'insert (310) entre ses deux surfaces de connexion étant inférieure à la distance entre les deux surfaces de raccordement lorsque le matériau isolant du support (304) est au repos, et supérieure ou égale à ladite distance lorsque le matériau est entièrement déformé par compression entre ses surfaces de raccordement.

6. Bloc fonctionnel selon la revendication 5 dans lequel le câble de raccordement (300) est symétrique et blindé.

7. Bloc fonctionnel selon l'une des revendications 4 à 6 dans lequel les moyens de raccordement d'entrée et de sortie du bloc (40) sont raccordés entre eux par des barres de connexion (100) munies à chaque extrémité d'un dispositif de raccordement (102) comprenant :
- un support (104) du matériau isolant délimité par deux surfaces de raccordement opposées sensiblement parallèles ;
- un insert de connexion conducteur (110) intégré dans le support isolant (104) et débouchant sur les deux surfaces de raccordement au niveau de deux surfaces de connexion planes parallèles, la hauteur de l'insert (110) entre ses deux surfaces de connexion étant inférieure à la distance entre les deux surfaces de raccordement lorsque le matériau isolant du support (104) est au repos, et supérieure ou égale à ladite distance lorsque le matériau est entièrement déformé par compression entre ses surfaces de raccordement.

8. Bloc fonctionnel selon la revendication 7 comprenant en outre des auxiliaires de raccordement (400) comprenant un insert conducteur enrobé dans un support isolant dont il débouche au niveau de deux surfaces de connexion (402) au centre de deux disques orientés à 90° l'un de l'autre.

9. Bloc fonctionnel selon l'une des revendications 1 à 8 comprenant en outre des moyens de mesure du courant (46) logés dans un deuxième logement de l'enveloppe (42), différent du premier logement (40').

10. Bloc fonctionnel selon la revendication 9 dans lequel les moyens de mesure du courant (46) sont directement accessibles depuis une deuxième face de l'enveloppe (42) orthogonale à la face d'accès.

11. Bloc fonctionnel selon la revendication 8 comprenant trois barres de raccordement (100) dans un deuxième logement de l'enveloppe (42), différent du premier logement (40'), et reliant les moyens de raccordement d'arrivée et de sortie, et au moins un tore de mesure du courant (46) disposé autour d'une barre de raccordement (100).

12. Unité fonctionnelle de mesure comprenant un bloc fonctionnel (40) selon l'une des revendications 1 à 11 et un compartiment (8) localisé sous ledit bloc (40) et adapté pour le passage de câbles.

13. Poste de distribution moyenne tension comprenant une pluralité d'unités fonctionnelles dont une au moins est définie selon la revendication 12, lesdites unités étant reliées entre elles au niveau de leurs moyens de raccordement par des barres de connexion (100) munies à chaque extrémité d'un dispositif de raccordement (102) comprenant :
- un support (104) du matériau isolant délimité par deux surfaces de raccordement opposées sensiblement parallèles ;
- un insert de connexion conducteur (110) intégré dans le support isolant (104) et débouchant sur les deux surfaces de raccordement au niveau de deux surfaces de connexion planes parallèles, la hauteur de l'insert (110) entre ses deux surfaces de connexion étant inférieure à la distance entre les deux surfaces de raccordement lorsque le matériau isolant du support (104) est au repos, et supérieure ou égale à ladite distance lorsque le matériau est entièrement déformé par compression entre ses surfaces de raccordement.

## Patentansprüche

1. Messfunktionsblock (40) für eine Mittelspannungs-Verteilungsstation (1), der eine rechtwinklige parallelepipedische Hülle (42), drei Anschlusseinrichtungen für die Stromzufuhr, drei Anschlusseinrichtungen für den Stromausgang und Einrichtungen zur Messung der Spannung (44) enthält, **dadurch gekennzeichnet, dass**:
- die Anschlusseinrichtungen an der Zufuhr bzw. am Ausgang in zwei parallelen Ebenen ausgerichtet sind;
- die Hülle (42) eine erste Aufnahme (40') für die Einrichtungen zur Messung der Spannung (44) enthält, wobei das Abteil (40') direkt von einer Zugangsseite der Hülle (42) orthogonal zu den Ebenen der Anschlusseinrichtungen zugänglich ist;
- die Einrichtungen zur Messung der Spannung (44) Anschlussklemmen (48) enthalten, die sich in einer Ebene parallel zur Zugangsseite befinden;
- die Anschlussklemmen (48) der Messeinrichtungen (44) mit den Anschlusseinrichtungen des Blocks (40) über biegsame Kabel (300) verbunden sind.

2. Funktionsblock nach Anspruch 1, der drei abgeschirmte Spannungssensoren (44) enthält, deren Klemmen (48) orthogonal zur Ebene der Anschlusseinrichtungen ausgerichtet sind.

3. Funktionsblock nach einem der Ansprüche 1 oder 2, wobei die Klemmen (48) der Einrichtungen zur Messung der Spannung (44) einen Axialleiter enthalten, der mit einem Isolierungsträger umhüllt ist, der teilweise mit einer Abschirmung bedeckt ist, so dass die Anschlussfläche der Klemme (48) eine Scheibe ist, in der eine Verbindungsfläche des Leiters zentriert ist.

4. Funktionsblock nach einem der Ansprüche 1 bis 3, wobei die Anschlusseinrichtungen des Blocks (40) einen Axialleiter (110, 410) enthalten, der mit einem Isolierungsträger (104, 404) umhüllt ist, der teilweise mit einer Abschirmung bedeckt ist, so dass die Anschlusseinrichtungen eine Anschlussfläche bilden, die aus einer Scheibe besteht, in der eine Verbindungsfläche des Leiters zentriert ist.

5. Funktionsblock nach einem der Ansprüche 3 oder 4, wobei das eine Klemme (48) der Einrichtungen zur Messung der Spannung (44) mit den Anschlusseinrichtungen des Blocks (40) verbindende Anschlusskabel (300) mit einer Anschlussvorrichtung (302) versehen ist, die enthält:
- einen Träger (304) des Isoliermaterials, der von zwei gegenüberliegenden Anschlussflächen begrenzt wird, die im Wesentlichen parallel und auf eine Scheibe stapelbar sind;
- einen leitenden Verbindungseinsatz (310), der in den Isolierungsträger (304) integriert ist und an den zwei Anschlussflächen im Bereich von zwei parallelen ebenen Verbindungsflächen mündet, die auf die Verbindungsfläche der Scheibe stapelbar sind, wobei die Höhe des Einsatzes (310) zwischen seinen zwei Verbindungsflächen geringer als der Abstand zwischen den zwei Anschlussflächen, wenn das Isoliermaterial des Trägers (304) in Ruhestellung ist, und größer als der oder gleich dem Abstand ist, wenn das Material durch Komprimierung zwischen seinen Anschlussflächen vollständig verformt ist.

6. Funktionsblock nach Anspruch 5, wobei das Anschlusskabel (300) symmetrisch und abgeschirmt ist.

7. Funktionsblock nach einem der Ansprüche 4 bis 6, wobei die Eingangs- und Ausgangs-Anschlusseinrichtungen des Blocks (40) durch Verbindungsstangen (100) aneinander angeschlossen sind, die an jedem Ende mit einer Anschlussvorrichtung (102) vorgesehen sind, die enthält:
- einen Träger (104) des Isoliermaterials, der von zwei im Wesentlichen parallelen gegenüberliegenden Anschlussseiten begrenzt wird;
- einen leitenden Verbindungseinsatz (110), der in den Isolierungsträger (104) integriert ist und an den zwei Anschlussflächen im Bereich von zwei parallelen ebenen Verbindungsflächen mündet, wobei die Höhe des Einsatzes (110) zwischen seinen zwei Verbindungsflächen geringer als der Abstand zwischen den zwei Anschlussflächen, wenn das Isoliermaterial des Trägers (104) in der Ruhestellung ist, und größer als der oder gleich dem Abstand ist, wenn das Material durch Komprimierung zwischen seinen Anschlussflächen vollständig verformt ist.

8. Funktionsblock nach Anspruch 7, der außerdem Anschlusshilfseinrichtungen (400) enthält, die einen leitenden Einsatz enthalten, der von einem Isolierungsträger umhüllt ist, von dem er im Bereich von zwei Verbindungsflächen (402) in der Mitte von zwei zueinander um 90° ausgerichteten Scheiben mündet.

9. Funktionsblock nach einem der Ansprüche 1 bis 8, der außerdem Messeinrichtungen des Stroms (46) enthält, die in einer zweiten Aufnahme der Hülle (42) untergebracht sind, die sich von der ersten Aufnahme (40') unterscheidet.

10. Funktionsblock nach Anspruch 9, wobei die Messeinrichtungen des Stroms (46) von einer zweiten Seite der Hülle (42) orthogonal zur Zugangsseite direkt zugänglich sind.

11. Funktionsblock nach Anspruch 8, der drei Anschlussstangen (100) in einer zweiten Aufnahme der Hülle (42), die sich von der ersten Aufnahme (40') unterscheidet, und die Zufuhr- und Ausgangsanschlusseinrichtungen verbinden, und mindestens einen Messtorus des Stroms (46) enthält, der um eine Anschlussstange (100) herum angeordnet ist.

12. Messfunktionseinheit, die einen Funktionsblock (40) nach einem der Ansprüche 1 bis 11 und ein Abteil (8) enthält, das sich unter dem Block (40) befindet und für den Durchgang von Kabeln geeignet ist.

13. Mittelspannungs-Verteilungsstation, die eine Vielzahl von Funktionseinheiten enthält, von denen mindestens eine nach Anspruch 12 definiert ist, wobei die Einheiten im Bereich ihrer Anschlusseinrichtungen durch Verbindungsstangen (100) miteinander verbunden sind, die an jedem Ende mit einer Anschlussvorrichtung (102) versehen sind, die enthält:
- einen Träger (104) des Isoliermaterials, der von zwei im Wesentlichen parallelen gegenüberliegenden Anschlussflächen begrenzt wird;
- einen leitenden Verbindungseinsatz (110), der in den Isolierungsträger (104) integriert ist und an den zwei Anschlussflächen im Bereich von zwei parallelen ebenen Verbindungsflächen mündet, wobei die Höhe des Einsatzes (110) zwischen seinen zwei Verbindungsflächen geringer als der Abstand zwischen den zwei Anschlussflächen, wenn das Isoliermaterial des Trägers (104) in der Ruhestellung ist, und größer als der oder gleich dem Abstand ist, wenn das Material durch Komprimierung zwischen seinen Anschlussflächen vollständig verformt ist.

## Claims

1. Functional measuring block (40) for a medium-voltage substation (1), said block comprising a rectangular parallelepipedal casing (42), three connecting means for the current input, three connecting means for the current output, and means (44) for measuring voltage, **characterized in that**:
- the input connecting means and the output connecting means are aligned in two parallel planes, respectively;
- the casing (42) comprises a first housing (40') for the means (44) for measuring voltage, said compartment (40') being accessible directly from an access face of the casing (42) orthogonal to the planes of the connecting means;
- the means (44) for measuring voltage comprise connecting terminals (48) that are located in a plane parallel to the access face;
- the connecting terminals (48) of the measuring means (44) are connected to the connecting means of the block (40) via flexible cables (300).

2. Functional block according to Claim 1, comprising three shielded voltage sensors (44) the terminals (48) of which are aligned orthogonally to the plane of the connecting means.

3. Functional block according to either of Claims 1 and 2, wherein the terminals (48) of the means (44) for measuring voltage comprise an axial conductor coated in an insulator that is partially covered by a shield, so that the connecting surface of the terminal (48) is a disc in which a connection surface of the conductor is centred.

4. Functional block according to one of Claims 1 to 3, wherein the connecting means of the block (40) comprise an axial conductor (110, 410) coated in an insulator (104, 404) that is partially covered by a shield, so that the connecting means form a connecting surface composed of a disc in which a connection surface of the conductor is centred.

5. Functional block according to one of Claims 3 or 4, wherein the connecting cable (300) linking a terminal (48) of the means (44) for measuring voltage to the connecting means of the block (40) is equipped with a connecting device (302) that comprises:
- an insulator (304) made of insulating material, bounded by two substantially parallel opposite connecting surfaces that are superposable on a disc;
- a conductive connection insert (310) that is integrated into the insulator (304) and that emerges on the two connecting surfaces level with two parallel planar connection surfaces that are superposable on the connection surface of said disc, the height of the insert (310) between its two connection surfaces being smaller than the distance between the two connecting surfaces when the insulating material of the insulator (304) is at rest, and larger than or equal to said distance when the material is entirely deformed by compression between its connecting surfaces.

6. Functional block according to Claim 5, wherein the connecting cable (300) is symmetric and shielded.

7. Functional block according to one of Claims 4 to 6, wherein the input and output connecting means of the block (40) are connected together by connection bars (100) equipped at each end with a connecting device (102) comprising:
- an insulator (104) made of insulating material, bounded by two substantially parallel opposite connecting surfaces;
- a conductive connection insert (110) that is integrated into the insulator (104) and that emerges on the two connecting surfaces level with two parallel planar connection surfaces, the height of the insert (110) between its two connection surfaces being smaller than the distance between the two connecting surfaces when the insulating material of the insulator (104) is at rest, and larger than or equal to said distance when the material is entirely deformed by compression between its connecting surfaces.

8. Functional block according to Claim 7, furthermore comprising connecting auxiliaries (400) comprising a conductive insert coated in an insulator and from which it emerges level with two connection surfaces (402) at the centre of two discs that are oriented at 90° to each other.

9. Functional block according to one of Claims 1 to 8, furthermore comprising means (46) for measuring current, said means being housed in a second housing of the casing (42), said housing being different from the first housing (40').

10. Functional block according to Claim 9, wherein the means (46) for measuring current are accessible directly from a second face of the casing (42) orthogonal to the access face.

11. Functional block according to Claim 8, comprising three connecting bars (100) in a second housing of the casing (42), which housing is different from the first housing (40'), and linking the input and output connecting means and at least one toroid (46) for measuring current, which is arranged around a connecting bar (100).

12. Functional measuring unit comprising a functional block (40) according to one of Claims 1 to 11 and a compartment (8) located under said block (40) and adapted for the passage of cables.

13. Medium-voltage substation comprising a plurality of functional units at least one of which is defined according to Claim 12, said units being connected together via their connecting means by connection bars (100) that are equipped at each end with a connecting device (102) comprising:
- an insulator (104) made of insulating material, bounded by two substantially parallel opposite connecting surfaces;
- a conductive connection insert (110) that is integrated into the insulator (104) and that emerges on the two connecting surfaces level with two parallel planar connection surfaces, the height of the insert (110) between its two connection surfaces being smaller than the distance between the two connecting surfaces when the insulating material of the insulator (104) is at rest, and larger than or equal to said distance when the material is entirely deformed by compression between its connecting surfaces.
